# EUROPEAN PATENT APPLICATION

(11) **EP 2 075 850 A2**
(43) Date of publication of application: **01.07.2009**
(21) Application number: 08021559.3
(22) Date of filing: 11.12.2008
(51) Int. Cl.: H01L 31/028, H01L 31/0392, H01L 31/068, H01L 31/18

(54) **Photoelectric conversion device and manufacturing method thereof**

(30) Priority: 28.12.2007 JP 2007340320
(71) Applicant: Semiconductor Energy Laboratory Co, Ltd., Atsugi-shi, Kanagawa 243-0036 (JP)
(72) Inventor: Yamazaki, Shunpei, Kanagawa-ken 243-0036 (JP); Ikeda, Hisao, Kanagawa-ken 243-0036 (JP); Seo, Satoshi, Kanagawa-ken 243-0036 (JP)
(74) Representative: Grünecker, Kinkeldey, Stockmair & Schwanhäusser Anwaltssozietät

(57) **Abstract**

A photoelectric conversion device includes a first unit cell (104) in which one face of a single crystal semiconductor layer is provided with a first electrode (103) and a first impurity semiconductor layer (107) including one conductivity type and an opposite face is provided with a second impurity semiconductor layer (108) including a conductivity type opposite to the one conductivity type, and a second unit cell (105) including a p-type organic semiconductor (110) and an n-type organic semiconductor (111). The first unit cell and the second unit cell are connected in series with an intermediate layer (141) interposed therebetween. The intermediate layer includes a transition metal oxide. A face of the first electrode which is opposite to the single crystal semiconductor layer is provided with an insulating layer (102), and the insulating layer is bonded to a supporting substrate (101).

## Description

### BACKGROUND OF THE INVENTION

### 1. Field of the Invention

The present invention relates to a photoelectric conversion device using a single crystal semiconductor or a polycrystalline semiconductor, and to a so-called tandem photoelectric conversion device in which a plurality of photoelectric conversion elements is stacked.

### 2. Description of the Related Art

As a measure against global warming, solar photovoltaic power generation has been spreading around the world. For the solar photovoltaic power generation, a photoelectric conversion device (also called a photovoltaic device or a solar cell) in which light energy is converted into electrical energy by using photoelectric characteristics of a semiconductor is applied in many cases, as compared to the case of using solar heat.

Production of photoelectric conversion devices increases year after year. For example, the world's total production of solar cells in 2005 was increased by 47% from the previous fiscal year to 1,759 MW. Photoelectric conversion devices which have become popular worldwide are photoelectric conversion devices using a crystalline semiconductor; photoelectric conversion devices using a single crystal silicon substrate or a polycrystalline silicon substrate account for a large part of the production.

A crystalline photoelectric conversion device using silicon requires a thickness of about 10 µm, which is thick enough to absorb sunlight. Nevertheless, a single crystal silicon substrate or a polycrystalline silicon substrate manufactured as a product has a thickness of about 200 µm to 300 µm. That is, the photoelectric conversion device using a single crystal semiconductor substrate or a polycrystalline semiconductor substrate has a thickness ten or more times as large as the thickness needed for photoelectric conversion, and thus the single crystal silicon substrate or the polycrystalline silicon substrate is far from being effectively used wholly. Speaking of extremes, most part of the single crystal silicon substrate or the polycrystalline silicon substrate functions only as a structural body for keeping the shape of the photoelectric conversion device.

With the increase in production of photoelectric conversion devices year after year, shortage in supply of polycrystalline silicon, which is a material of a silicon substrate, and resulting rise in cost of same have become problems in the industry. The world production of polycrystalline silicon including polycrystalline silicon for semiconductors in 2006 was about 37,000 tons, 11,000 tons of which is demanded for solar cells. Production of solar cells is increasing year by year and the demand has already been tight.

There are a variety of structures of photoelectric conversion devices. In addition to a photoelectric conversion device having a typical structure in which an n-type or p-type diffusion layer is formed in a single crystal silicon substrate or a polycrystalline silicon substrate, a stacked photoelectric conversion device in which different kinds of unit cells, e.g., a unit cell formed of a single crystal semiconductor and a unit cell formed of an amorphous semiconductor, are combined is known (see Reference 1: Examined Patent Application Publication No. H6-044638). The photoelectric conversion device is not different from a conventional device in that a single crystal semiconductor substrate or a polycrystalline semiconductor substrate is used.

On the other hand, photoelectric conversion devices using a crystalline silicon thin film have also been developed. For example, a method of manufacturing a silicon thin-film solar cell in which a crystalline silicon film is deposited over a substrate by a plasma CVD method using a frequency of 27 MHz or more which has been pulse-modulated is disclosed (see Reference 2: Japanese Published Patent Application No. 2005-50905). Further, a technique for controlling plasma process condition to the optimize dopant concentration in crystal grains and crystal grain boundaries when a polycrystalline silicon thin film is formed by a plasma CVD method over a special electrode called a "texture electrode" which has minute unevenness on its surface is disclosed (see Reference 3: Japanese Published Patent Application No. 2004-14958).

### SUMMARY OF THE INVENTION

However, a crystalline silicon thin-film solar cell is still inferior to a single crystal silicon solar cell in crystal quality and photoelectric conversion characteristic. Moreover, a crystalline silicon film needs to be deposited to a thickness of 1 µm or more by a chemical vapor deposition method, which leads to a problem of low productivity. In a conventional technique, it has been difficult to produce photoelectric conversion devices enough to meet the demand, with limited resources effectively used. In view of such circumstances, it is an object of the present invention to provide a photoelectric conversion device with an excellent photoelectric conversion characteristic with a silicon semiconductor material effectively used, and a manufacturing method thereof.

As described in Reference 1, in a stacked photoelectric conversion device, connection between unit cells is important for improvement of characteristics. Thus, an object of the present invention is to provide a stacked photoelectric conversion device with good connection between unit cells and a manufacturing method thereof.

According to the present invention, a photoelectric conversion device includes a first unit cell that includes a single crystal semiconductor layer with a thickness of 10 µm or less in a photoelectric conversion layer and a second unit cell that includes a p-type organic semiconductor and an n-type organic semiconductor in a photoelectric conversion layer over the first unit cell. An intermediate layer including a transition metal oxide is provided between the first unit cell and the second unit cell.

An aspect of a photoelectric conversion device of the present invention includes a first unit cell in which one face of a single crystal semiconductor layer is provided with a first electrode and a first impurity semiconductor layer including one conductivity type and an opposite face is provided with a second impurity semiconductor layer including a conductivity type opposite to the one conductivity type, and a second unit cell including a p-type organic semiconductor and an n-type organic semiconductor. The first unit cell and the second unit cell are connected in series with an intermediate layer interposed therebetween. The intermediate layer includes a transition metal oxide. A face of the first electrode which is opposite to the single crystal semiconductor layer is provided with an insulating layer, and the insulating layer is bonded to a supporting substrate.

In an aspect of a method of manufacturing a photoelectric conversion device of the present invention, a cluster ion is introduced to one face of a single crystal semiconductor substrate at a depth of 10 µm or less from a surface of the single crystal semiconductor substrate to form a damaged layer, and a first impurity semiconductor layer, a first electrode, and an insulating layer are formed on the one face side; the insulating layer is bonded to a supporting substrate, and the single crystal semiconductor substrate is cleaved along the damaged layer to make a single crystal semiconductor layer remain over the supporting substrate; a second impurity semiconductor layer is formed on a cleavage plane side of the single crystal semiconductor layer; an intermediate layer is formed over the second impurity semiconductor layer; a second unit cell including a p-type organic semiconductor and an n-type organic semiconductor is formed over the intermediate layer; and a second electrode is formed over the second unit cell.

Note that 'single crystals' are crystals in which crystal faces are aligned with each other and crystal axes are aligned with each other and atoms or molecules which constitute the single crystals are aligned regularly in terms of space. Although single crystals are constituted by atoms aligned regularly, single crystals may include a lattice defect in which part of the alignment is disordered, or an intended or unintended lattice distortion.

In accordance with the present invention, a surface portion of a single crystal semiconductor substrate is thinned and bonded to a supporting substrate, whereby a photoelectric conversion device in which a top cell is stacked over a bottom cell can be obtained. The bottom cell uses a single crystal semiconductor layer with a thickness of 10 µm or less as a photoelectric conversion layer, and the top cell uses a layer including an organic semiconductor material as a photoelectric conversion layer. That is, a photoelectric conversion device can be manufactured in which a bottom cell using a single crystal semiconductor layer as a photoelectric conversion layer and a top cell which uses a layer including an organic semiconductor material as a photoelectric conversion layer and is stacked over the bottom cell, are provided over a large-area glass substrate having an upper temperature limit of 700°C or lower. The single crystal semiconductor layer is obtained by separation of the surface portion of the single crystal semiconductor substrate. The single crystal semiconductor substrate, which can be repeatedly used, enables effective use of resources.

In accordance to the present invention, the first unit cell and the second unit cell are connected to each other with the intermediate layer including the transition metal oxide interposed therebetween. Therefore, carrier recombination is performed efficiently between the first unit cell and the second unit cell, thereby reducing the internal photovoltaic effect between the first unit cell and the second unit cell, compared with a direct connection between a p-type semiconductor and an n-type semiconductor.

### BRIEF DESCRIPTION OF THE DRAWINGS

FIG 1 is a plan view illustrating a structure of a tandem photoelectric conversion device.
FIG 2 is a cross-sectional view illustrating a structure of a tandem photoelectric conversion device.
FIG 3 is a diagram illustrating an example of an energy band diagram of a tandem photoelectric conversion device.
FIG 4 is a cross-sectional view illustrating a structure of a stacked photoelectric conversion device.
FIG 5 is a diagram illustrating an example of an energy band diagram of a tandem photoelectric conversion device.
FIG 6 is a diagram illustrating an example of an energy band diagram of a tandem photoelectric conversion device.
FIG 7 is a diagram illustrating an example of an energy band diagram of a tandem photoelectric conversion device.
FIGS. 8A to 8D are cross-sectional views illustrating a manufacturing process of a stacked photoelectric conversion device.
FIGS. 9A and 9B are cross-sectional views illustrating a manufacturing process of a stacked photoelectric conversion device.
FIGS. 10A and 10B are cross-sectional views illustrating a manufacturing process of a stacked photoelectric conversion device.
FIGS. 11A to 11C are cross-sectional views illustrating a manufacturing process of a stacked photoelectric conversion device.
FIG 12 is a cross-sectional view illustrating a manufacturing process of a stacked photoelectric conversion device.
FIG 13 is a schematic diagram illustrating a structure of an ion doping apparatus.
FIG 14 is a schematic diagram illustrating a structure of a laser processing apparatus.
FIGS. 15A to 15C are cross-sectional views illustrating a manufacturing process of a stacked photoelectric conversion device.
FIGS. 16A to 16C are cross-sectional views illustrating a manufacturing process of a stacked photoelectric conversion device.
FIGS. 17A to 17C are cross-sectional views illustrating a manufacturing process of a stacked photoelectric conversion device.
FIGS. 18A to 18C are cross-sectional views illustrating a manufacturing process of a stacked photoelectric conversion device.
FIGS. 19A to 19C are cross-sectional views illustrating a manufacturing process of a stacked photoelectric conversion device.
FIGS. 20A and 20B are plan views illustrating a structure of a solar photovoltaic module.
FIG 21 is a diagram illustrating an example of a solar photovoltaic system.

### DETAILED DESCRIPTION OF THE INVENTION

### Embodiment Modes

Embodiment modes of the present invention will be described with reference to the drawings. It is to be noted that the present invention is not limited to the following description, and it is easily understood by those skilled in the art that modes and details thereof can be modified in various ways without departing from the sprit and scope of the present invention. Therefore, the present invention should not be construed as being limited to the description of the following embodiment modes. In the structures of the present invention described below, the same portions are denoted by the same reference numerals through the drawings.

### (Embodiment Mode 1)

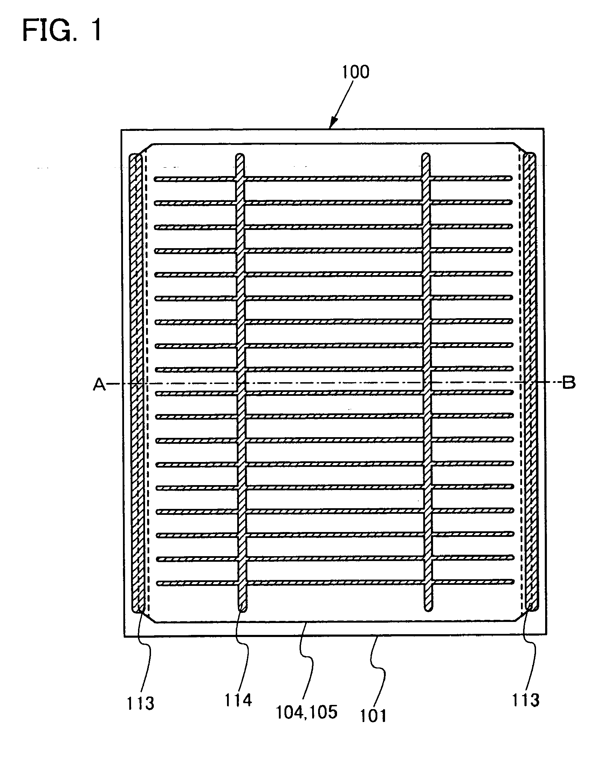

FIG 1 is a plan view of a photoelectric conversion device 100 of this embodiment mode. This photoelectric conversion device 100 includes a first unit cell 104 and a second unit cell 105 which are fixed over a supporting substrate 101. The first unit cell 104 and the second unit cell 105 include a semiconductor junction by which photoelectric conversion is performed.

The first unit cell 104 is provided with a first electrode on the supporting substrate 101 side, and the second unit cell 105 is provided with a second electrode on the surface side. The first electrode is connected to a first auxiliary electrode 113, and a second auxiliary electrode 114 is provided over the second electrode. The photoelectric conversion device 100 of this embodiment mode has a structure in which the first unit cell 104 and the second unit cell 105 are stacked over the supporting substrate 101 having an insulating surface; therefore, positive and negative electrodes are exposed on the same surface side of the supporting substrate 101.

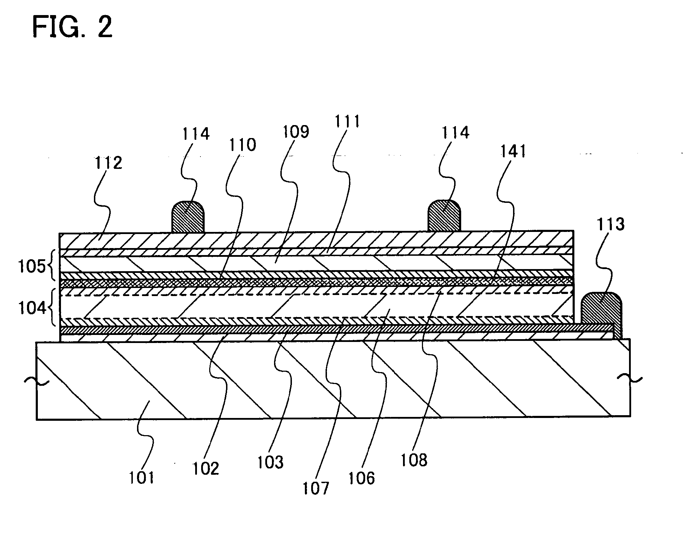

A cross-sectional structure of the photoelectric conversion device along section line A-B of FIG 1 is illustrated in FIG 2. FIG 2 illustrates a so-called tandem photoelectric conversion device in which the first unit cell 104 and the second unit cell 105 are stacked over the supporting substrate 101. The supporting substrate 101 is a substrate having an insulating surface or an insulating substrate; for example, any of a variety of glass substrates that are used in the electronic industry, such as an aluminosilicate glass substrate, an aluminoborosilicate glass substrate, and a barium borosilicate glass substrate, can be used.

An insulating layer 102 is provided between the supporting substrate 101 and the first unit cell 104. A first electrode 103 is provided between the first unit cell 104 and the insulating layer 102, and a second electrode 112 is provided over the second unit cell 105. The insulating layer 102 is bonded to the supporting substrate 101 and disposed in close contact with the first electrode 103, whereby the first unit cell 104 and the second unit cell 105 are fixed over the supporting substrate 101. The insulating layer 102 is formed of an insulating film having a smooth surface and having a hydrophilic surface in order to be bonded to the supporting substrate 101.

Single crystal silicon is typically used for a single crystal semiconductor layer 106 in the first unit cell 104. Alternatively, a polycrystalline semiconductor (typically polycrystalline silicon) layer can also be used instead of the single crystal semiconductor layer. A first impurity semiconductor layer 107 including one conductivity type and a second impurity semiconductor layer 108 including a conductivity type opposite to the one conductivity type are each formed by adding a predetermined impurity to the single crystal semiconductor layer 106. When the first impurity semiconductor layer 107 has p-type conductivity, the second impurity semiconductor layer 108 has n-type conductivity, and vice versa. As the p-type impurity, an element belonging to Group 13 in the periodic table of elements, such as boron, is used; as the n-type impurity, an element belonging to Group 15 in the periodic table of elements, such as phosphorus or arsenic, is used. An impurity element can be added by ion implantation or ion doping. In this specification, ion implantation indicates a method by which an ionized gas which has been subjected to mass separation is introduced into a semiconductor, and ion doping indicates a method by which an ionized gas which has not been subjected to mass separation is introduced into a semiconductor.

The single crystal semiconductor layer 106 is obtained by thinning a single crystal semiconductor substrate. For example, the single crystal semiconductor layer 106 is formed by a hydrogen ion implantation separation method in which hydrogen ions are introduced into a single crystal semiconductor substrate at a predetermined depth at a high concentration and then thermal treatment is performed to separate a single crystal semiconductor layer of a surface portion of the single crystal semiconductor substrate. Alternatively, a method may be employed in which a single crystal semiconductor is epitaxially grown on porous silicon and a porous silicon layer is separated by cleavage by water-jetting. As the single crystal semiconductor substrate, a single crystal silicon wafer is typically used. The thickness of the single crystal semiconductor layer 106 is equal to or more than 0.1 µm and equal to or less than 10 µm, preferably equal to or more than 1 µm and equal to or less than 5 µm. In the case of using a single crystal silicon semiconductor for the single crystal semiconductor layer 106, the single crystal semiconductor layer 106 needs to have a thickness in the above range to absorb sunlight since the single crystal silicon semiconductor has an energy gap of 1.12 eV and is of indirect transition type.

Alternatively, an amorphous semiconductor layer may be formed over a layer formed by thinning a single crystal semiconductor substrate, and may be crystallized by laser irradiation or heat treatment, whereby a single crystal semiconductor layer is formed and may be used as the single crystal semiconductor layer 106. By this method, the single crystal semiconductor layer 106 can be easily made thick.

The first unit cell and the second unit cell are connected in series with an intermediate layer interposed therebetween. In the photoelectric conversion device of the present invention, the intermediate layer includes a transition metal oxide. In the transition metal oxide, an oxide of a metal belonging to Groups 4 to 8 in the periodic table of elements is preferable. In particular, it is preferable to use vanadium oxide, niobium oxide, tantalum oxide, chromium oxide, molybdenum oxide, tungsten oxide, manganese oxide, or rhenium oxide because of their high electron accepting properties. Among these, a molybdenum oxide is particularly preferable since it is stable even in the air and has a low hygroscopic property, so that it can be easily treated.

It is preferable that the intermediate layer have a high light-transmitting property. Since the photoelectric conversion device of this embodiment mode has a structure in which light enters from the second electrode 112 side, light that enters from the second electrode 112 side is absorbed by the second unit cell 105, and light that is not absorbed by the second unit cell 105 passes through the intermediate layer 141 and is absorbed by the first unit cell 104. Accordingly, it is preferable that the intermediate layer 141 have high transmissivity with respect to, in particular, light of a wavelength that is absorbed by the first unit cell 104.

It is preferable that the intermediate layer 141 have a thickness of equal to or more than 1 nm and equal to or less than 50 nm.

Various methods can be used for forming the intermediate layer, regardless of a dry method or a wet method. Further, different formation methods may be employed for each layer. Among dry methods are a vacuum evaporation method, a sputtering method, and the like, for example. In an example of the wet process, a composition is adjusted by a sol-gel method or the like using metal alkoxide, and an ink-jet method, a spin coating method, or the like is used to form a film.

The photoelectric conversion layer of the second unit cell 105 includes a p-type organic semiconductor and an n-type organic semiconductor. The second unit cell may have a functional layer such as an electron blocking layer, a hole transporting layer, an electron transporting layer, a hole blocking layer, or a buffer layer besides the photoelectric conversion layer. In addition, any structure may be used for the photoelectric conversion layer as long as it includes a p-type organic semiconductor material and an n-type organic semiconductor material, and the structure of the photoelectric conversion layer may be a heterojunction structure in which a p-type organic semiconductor layer and an n-type organic semiconductor layer are stacked, or may be a bulk heterojunction structure in which a p-type organic semiconductor and an n-type organic semiconductor are mixed. By having a bulk heterojunction structure, a defect of a short carrier diffusion length of an organic layer can be compensated, and photoelectric conversion efficiency can be improved.

In this embodiment mode, as an example of a structure of the second unit cell, a structure is described in which a p layer 110 including a p-type organic semiconductor, an i layer 109 in which a p-type organic semiconductor and an n-type organic semiconductor are mixed, and an n layer 111 including an n-type organic semiconductor are stacked. That is, the second unit cell having a bulk heterojunction structure is described.

As an organic semiconductor material used for the second unit cell, either of a low molecular compound and a high molecular compound can be used, and the type thereof is not particularly limited. For example, as the organic semiconductor material, a polycyclic aromatic compound, a conjugated double bond compound, a macrocyclic compound, a metallophthalocyanine complex, a charge transfer complex, condensed ring tetracarboxylic diimides, oligothiophenes, fullerenes, carbon nanotubes, and the like can be given.

As the p-type organic semiconductor, an organic compound (a donor organic semiconductor) having an electron-donating property can be used. Specifically, the following materials can be given: a triarylamine compound, a benzidine compound, a pyrazoline compound, a styrylamine compound, a hydrazone compound, a triphenylmethane compound, a carbazole compound, a polysilane compound, a thiophene compound, a phthalocyanine compound, a cyanine compound, a merocyanine compound, an oxonol compound, a polyamine compound, an indole compound, a pyrrole compound, a pyrazole compound, a polyarene compound, a condensed aromatic carbocyclic compound (a naphthalene derivative, an anthracene derivative, a phenanthrene derivative, a tetracene derivative, a pyrene derivative, a perylene derivative, and a fluoranthene derivative), a metal complex in which a nitrogen-containing heterocyclic compound is used as a ligand, and the like. Note that the present invention is not limited to these, and as long as an organic compound which has smaller ionization potential than the organic compound used as an n-type semiconductor (acceptor organic semiconductor) is used, the organic compound which has smaller ionization potential can be used as a donor organic semiconductor.

As an n-type organic semiconductor, an organic compound having an acceptor property (acceptor organic semiconductor) can be used. Specifically, the following materials can be given: condensed aromatic carbocyclic compounds (a naphthalene derivative, an anthracene derivative, a phenanthrene derivative, a tetracene derivative, a pyrene derivative, a perylene derivative, and a fluoranthene derivative), 5- to 7-membered heterocyclic compounds which contain any of a nitrogen atom, an oxygen atom, or a sulfur atom (e.g., pyridine, pyrazine, pyrimidine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyrrolopyridine, thiadiazolopyridine, dibenzazepine, tribenzazepine, and the like), a polyarylene compound, a fluorene compound, a cyclopentadiene compound, silyl compound, a metal complex in which a nitrogen-containing heterocyclic compound is used as a ligand, and the like. Note that the present invention is not limited to these, and as long as an organic compound which has higher electron affinity than the organic compound (donor organic semiconductor) used as a p-type semiconductor, the organic compound which has higher electron affinity can be used as an acceptor organic semiconductor. Fullerenes, carbon nanotubes, or the like can also be used.

Various methods can be used as a method of forming the second unit cell, regardless of a dry method or a wet method. Further, different formation methods may be employed for each layer. A vacuum evaporation method, a sputtering method, or the like can be employed as a dry method. An ink-jet method, a spin-coating method, or the like can be employed as a wet method. A transfer method such as heat transfer or laser transfer may also be used.

Note that it is preferable that a wavelength region of light that is absorbed by the first unit cell be different from a wavelength region of light that is absorbed by the second unit cell. The energy gaps of many organic semiconductor materials are larger than that of single crystal silicon. Therefore, an organic semiconductor material having a larger energy gap than single crystal silicon and an absorption maximum in a wavelength region (e.g., shorter wavelength than 800 nm) in which single crystal silicon has a small absorption coefficient is used, whereby light with a wavelength region shorter than 800 nm can be absorbed by the second unit cell and converted into electricity. In this manner, wavelength ranges of light that are absorbed by their respective unit cells are different from each other, whereby sunlight can be absorbed efficiently.

The photoelectric conversion device of this embodiment mode has a structure in which light enters from the second electrode 112 side. The second electrode 112 is formed using a transparent electrode material such as indium tin oxide, tin oxide, or zinc oxide. The first electrode 103 is formed using a metal material selected from titanium, molybdenum, tungsten, tantalum, chromium, and nickel. In addition, the first electrode 103 has a nitride layer of titanium, molybdenum, tungsten, or tantalum and the nitride layer is in contact with the first impurity semiconductor layer 107. Adhesion can be improved by interposing a metal nitride between the semiconductor layer and a metal layer.

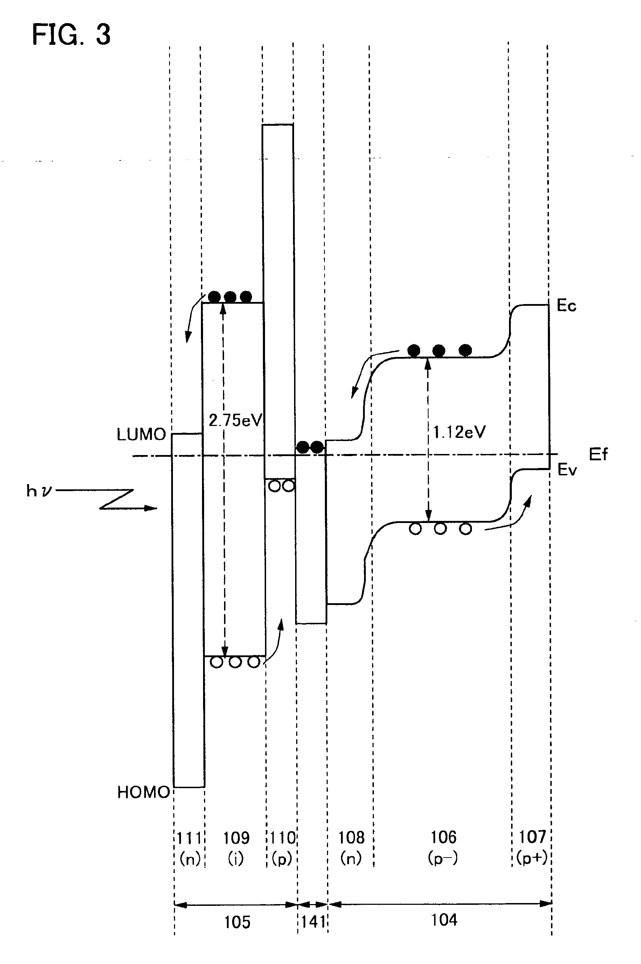

FIG 3 illustrates an energy band diagram in the case where the first unit cell 104 that has the single crystal semiconductor layer 106 having an energy gap of 1.12 eV and the second unit cell 105 that has the i layer 109 having an energy gap of 2.75 eV are used. The second unit cell 105 that has the i layer 109 having a large energy gap is located on the light incident side, and the first unit cell 104 that has the single crystal semiconductor layer 106 having a small energy gap is located posterior to the second unit cell 105. Note that FIG 3 illustrates the case where the first impurity semiconductor layer 107 and the p layer 110 are p-type semiconductors, and the second impurity semiconductor layer 108 and the n layer 111 are n-type semiconductors.

As illustrated in the energy band diagram of FIG 3, electrons which are excited by absorbing light flow into the n-type semiconductor side, and holes which are excited by absorbing light flow into the p-type semiconductor side. When the intermediate layer 141 is not provided, the joint portion of the first unit cell 104 and the second unit cell 105 is provided with a p-n junction, and in terms of an equivalent circuit, a diode is inserted in an opposite direction to a current flow. That is, an internal electromotive force effect is produced. Since the intermediate layer 141 described in this embodiment mode is formed of the transition metal oxide, the intermediate layer 141 can make ohmic contact with the adjacent layer including an organic semiconductor. Accordingly, the layer formed of this transition metal oxide is used as the intermediate layer, whereby there is no energy barrier at an interface with the layer including an organic semiconductor and recombination of carriers can be performed smoothly. Thus, the internal electromotive force effect can be reduced, and high photoelectric conversion efficiency can be realized.

In the tandem photoelectric conversion device of FIG 2, the first unit cell 104 formed of the single crystal semiconductor layer is used as a bottom cell, whereby light with a long wavelength of 800 nm or more can be absorbed and converted into electricity. That is, light in the wavelength region that is not absorbed by the second unit cell 105 can be converted into electricity in the first unit cell 104, which contributes to an improvement in photoelectric conversion efficiency. In this case, the single crystal semiconductor layer 106 is thinned to be 10 µm or less, whereby loss of carriers due to recombination of photogenerated carriers can be reduced.

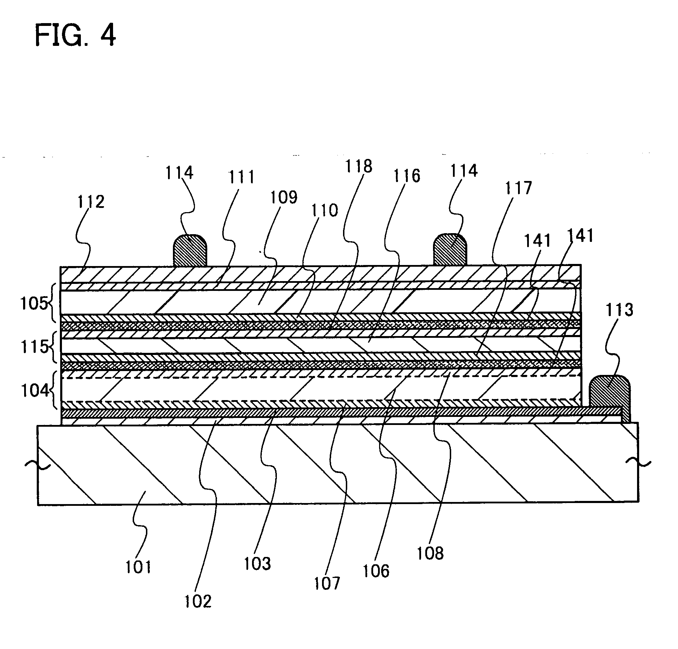

FIG 4 illustrates an example of a stacked-layer photoelectric conversion device (stacked photoelectric conversion device) in which three unit cells are stacked. In the first unit cell 104 provided over the supporting substrate 101, the single crystal semiconductor layer 106 is used as a photoelectric conversion layer. In a third unit cell 115 over the first unit cell 104, a non-single-crystal semiconductor layer 116 is used as a photoelectric conversion layer. In the second unit cell 105 over the third unit cell 115, the i layer 109 including an organic semiconductor material is used as a photoelectric conversion layer. Each unit cell is connected in series by an intermediate layer.

In this case, since the energy gap of the single crystal semiconductor layer 106 is 1.12 eV, it is preferable that the energy gap of the non-single-crystal semiconductor layer 116 in the third unit cell 115, which is located closer to the light incident side than the first unit cell 104, be 1.12 eV or more, and the energy gap of the i layer 109 including the organic semiconductor material in the second unit cell 105 be larger than that of the non-single-crystal semiconductor layer 116 in the third unit cell 115. This is because wavelength ranges of light absorbed by their respective unit cells are different from each other, whereby sunlight can be absorbed efficiently.

For example, when the energy gap of the non-single-crystal semiconductor layer 116 in the third unit cell 115 is from 1.45 eV to 1.65 eV, the energy gap of the i layer 109 including the organic semiconductor material in the second unit cell 105 may be larger than 1.65 eV In addition, when the energy gap of the non-single-crystal semiconductor layer 116 in the third unit cell 115 is from 1.7 eV to 2.0 eV, the energy gap of the i layer 109 including the organic semiconductor material in the second unit cell 105 may be larger than 2.1 eV Since the energy gap varies from material to material, an organic semiconductor material having a suitable energy gap can be selected as appropriate.

Note that amorphous silicon germanium or microcrystalline silicon is used so that the energy gap of the non-single-crystal semiconductor layer 116 in the third unit cell 115 can be from 1.45 eV to 1.65 eV Amorphous silicon (1.75 eV) or amorphous silicon carbide (from 1.8 eV to 2.0 eV) is used so that the energy gap of the non-single-crystal semiconductor layer 116 in the third unit cell 115 can be from 1.7 eV to 2.0 eV

For the non-single-crystal semiconductor layer 116 in the third unit cell 115, amorphous silicon is typically used. Alternatively, a microcrystalline semiconductor layer (typically microcrystalline silicon) can also be used instead of the amorphous semiconductor layer. A third impurity semiconductor layer 117 including one conductivity type and a fourth impurity semiconductor layer 118 including a conductivity type opposite to the one conductivity type are each formed of an amorphous semiconductor layer or a microcrystalline semiconductor layer including a predetermined impurity. Amorphous silicon or microcrystalline silicon is typically used, and alternatively, amorphous silicon carbide can be used. If the third impurity semiconductor layer 117 has p-type conductivity, the fourth impurity semiconductor layer 118 has n-type conductivity, and vice versa.

The non-single-crystal semiconductor layer 116 is formed by decomposing a reactive gas including a semiconductor source gas with electromagnetic energy. As the semiconductor source gas, a hydride of silicon typified by silane or disilane, a fluoride of silicon, or a chloride of silicon is used. Such a semiconductor source gas or a semiconductor source gas including hydrogen and/or an inert gas is used as the reactive gas. The non-single-crystal semiconductor layer 116 is formed by a plasma CVD apparatus using this reactive gas, with a high-frequency power of 10 MHz to 200 MHz applied as the electromagnetic energy. As the electromagnetic energy, a microwave power of 1 GHz to 5 GHz, typically 2.45 GHz may be applied instead of the high-frequency power. The third impurity semiconductor layer 117 and the fourth impurity semiconductor layer 118 are formed similarly by the plasma CVD apparatus in such a manner that diborane (B₂H₆) is added as the impurity to the reactive gas in the case of giving p-type conductivity and phosphine (PH₃) is added as the impurity to the reactive gas in the case of giving n-type conductivity. As the non-single-crystal semiconductor layer 116, an amorphous silicon layer is typically used. The thickness of the non-single-crystal semiconductor layer 116 is equal to or more than 50 nm and equal to or less than 300 nm, preferably equal to or more than 100 nm and equal to or less than 200 nm. In the case of using an amorphous silicon semiconductor, which has an energy gap of 1.75 eV, for the non-single-crystal semiconductor layer 116, the thickness of the above range allows the non-single-crystal semiconductor layer 116 to absorb light with a shorter wavelength than 600 nm to convert into electricity.

As the non-single-crystal semiconductor layer 116 in the third unit cell 115, a microcrystalline semiconductor layer (typically a microcrystalline silicon layer) can also be used. SiH₄ is a typical semiconductor source gas used for forming the microcrystalline semiconductor layer, and Si₂H₆ can alternatively be used. Further, SiH₂Cl₂, SiHCl₃, SiCl₄, SiF₄, or the like may be mixed to SiH₄ as appropriate. The microcrystalline semiconductor layer is formed by a plasma CVD method using this semiconductor source gas diluted with hydrogen; fluorine, or hydrogen or fluorine and one or more of noble gas elements of helium, argon, krypton, and neon. The dilution ratio of the semiconductor source gas to the above gas is preferably 1:10 to 1:3000. Deposition is performed by glow discharge plasma generated under a reduced pressure of about 0.1 Pa to 133 Pa. High-frequency power in the HF band or the VHF band of 10 MHz to 200 MHz, or microwave power of 1 GHz to 5 GHz may be used as the electric power for generating plasma. In addition, a carbide gas such as CH₄ or C₂H₆, or a germanium gas such as GeH₄ or GeF₄ mixed into the semiconductor source gas may be used, so that the width of the energy band can be adjusted to be 1.5 eV to 2.4 eV, or 0.9 eV to 1.1 eV. The microcrystalline semiconductor layer has lattice distortion, which changes the optical characteristics from indirect transition type of single crystal silicon to direct transition type. The lattice distortion of at least 10% causes the optical characteristics to change into direct transition type; however, local distortion produces optical characteristics in which direct transition and indirect transition are mixed. The microcrystalline silicon layer has an energy gap of about 1.45 eV, which is wider than that of single crystal silicon; therefore, light with a shorter wavelength than 600 nm can be absorbed and converted into electricity in the microcrystalline silicon layer.

Note that, although the third unit cell 115 using a non-single-crystal semiconductor layer is illustrated in FIG 4, the third unit cell 115 using an organic semiconductor layer may also be used. In that case, it is preferable that a wavelength region of light that is absorbed by the second unit cell 105 and a wavelength region of light that is absorbed by the third unit cell be different from each other. Since there are many choices on the organic semiconductor material and the energy gap thereof varies from material to material, a material to be used is easily selected so that a wavelength region of light that is absorbed by the second unit cell and a wavelength region of light that is absorbed by the third unit cell can be different from each other, and the organic semiconductor material can be preferably used for a stacked photoelectric conversion device.

### (Embodiment Mode 2)

In this embodiment mode, an intermediate layer which has a different structure from the intermediate layer described in Embodiment Mode 1 will be described.

A composite material including a transition metal oxide and an organic compound can be used as the intermediate layer 141 in FIG 2. In this specification, "composite" refers to not only a state in which two types of materials are simply mixed, but also a state in which electric charges are given and received between materials by the mixture of a plurality of materials.

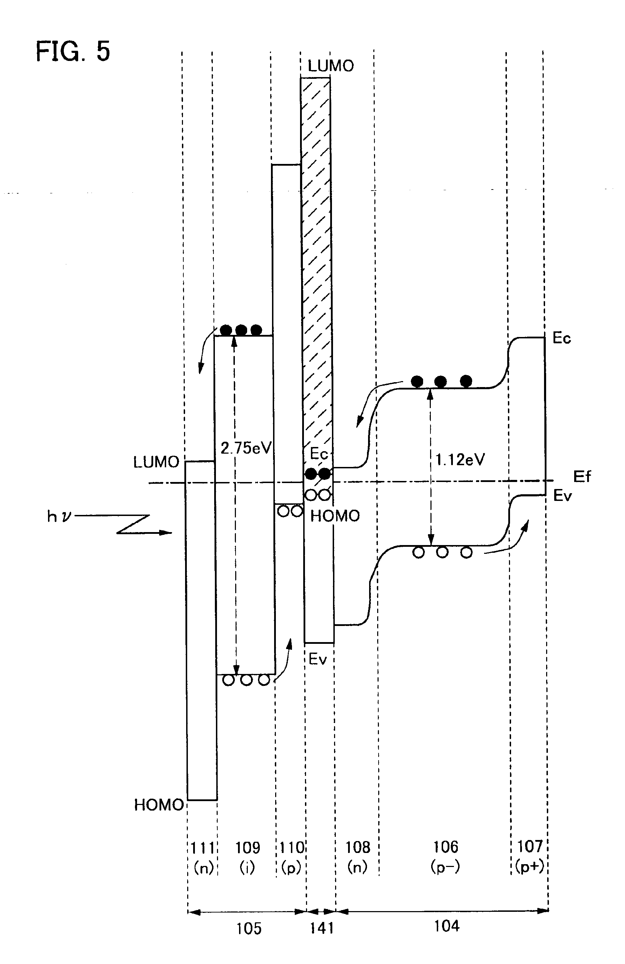

Since the composite material including the transition metal oxide and the organic compound has a large carrier density, the composite material can be preferably used as a recombination center. In FIG 5, an energy band diagram in the case where the composite material of the transition metal oxide and an organic compound is used as the intermediate layer 141 is illustrated. In the intermediate layer 141 described in this embodiment mode, electrons in the highest occupied molecular orbital level (HOMO level) of the organic compound move to a conduction band of the transition metal oxide, whereby interaction is generated between the transition metal oxide and the organic compound. With this interaction, the composite material including the transition metal oxide and the organic compound can have a large carrier density and make ohmic contact with an adjacent layer. Accordingly, this composite material is used for the intermediate layer, whereby there is no energy barrier at an interface with a layer and recombination of carriers can be performed smoothly. Thus, the internal electromotive force effect can be reduced, and high photoelectric conversion efficiency can be realized.

As illustrated in FIG 5, since an organic compound that has a large band gap is used for the composite material described in this embodiment mode, electrons generated in the i layer 109 including the organic semiconductor can be prevented from being diffused into the first unit cell 104.

The composite material including the transition metal oxide and the organic compound is used as the intermediate layer 141, whereby adhesion of a layer including an organic semiconductor material which is formed later can be improved. That is, adhesion can be improved compared to the case where the second unit cell using the organic semiconductor is formed over the first unit cell using the single crystal semiconductor.

As a transition metal compound which can be used for the intermediate layer 141, the transition metal oxide described in Embodiment Mode 1 can be given. Specifically, in the transition metal oxide, an oxide of a metal belonging to Groups 4 to 8 in the periodic table of elements is preferable. In particular, it is preferable to use vanadium oxide, niobium oxide, tantalum oxide, chromium oxide, molybdenum oxide, tungsten oxide, manganese oxide, or rhenium oxide because of their high electron accepting properties. Among these, molybdenum oxide is particularly preferable since it is stable in the air and its hygroscopic property is low so that it can be easily treated.

As the organic compound that can be used for the intermediate layer 141, various compounds such as an aromatic amine compound, a carbazole derivative, an aromatic hydrocarbon, or a high molecular compound (oligomer, dendrimer, polymer, or the like) can be used. The organic compound used for the composite material is preferably an organic compound having a high hole transporting property. Specifically, a substance having a hole mobility of 10⁻⁶ cm²/Vs or higher is preferably used. However, materials other than the above materials may be used as long as the material has a higher hole transporting property than an electron transporting property. The organic compound that can be used for the composite material is specifically listed below

As an organic compound that can be used for the composite material, various compounds such as an aromatic amine compound, a carbazole derivative, an aromatic hydrocarbon, or a high molecular compound (oligomer, dendrimer, polymer, or the like) can be used. Note that, as the organic compound to be used as the composite material, a substance having a hole mobility of 10⁻⁶ cm²/Vs or more is preferably used. However, materials other than the above materials may be used as long as the material has a higher hole transporting property than an electron transporting property. The organic compound that can be used for the composite material is specifically listed below.

As the aromatic amine compound that can be used for the composite material, the following can be given as examples: 4,4'-bis[*N*-(1-naphthyl)-*N*-phenylamino]biphenyl (abbreviation: NPB); *N,N'*-bis(3-methylphenyl)-*N,N*'-diphenyl[1,1'-biphenyl]-4,4'-diamine (abbreviation: TPD); 4,4',4"-tris(*N,N*-diphenylamino)triphenylamine (abbreviation: TDATA); 4,4',4"-tris[*N*-(3-methylphenyl)-*N*-phenylamino]triphenylamine (abbreviation: MTDATA); 4,4'-bis[*N*-(spiro-9,9'-bifluoren-2-yl)-*N*-phenylamino]-1,1'-biphenyl (abbreviation: BSPB); and the like. In addition, the following can be given as examples: *N,N'-*bis(4-methylphenyl)(p-tolyl)-*N,N'*-diphenyl-*p*-phenylenediamine (abbreviation: DTDPPA); 4,4'-bis[*N*-(4-diphenylaminophenyl)-*N*-phenylamino]biphenyl (abbreviation: DPAB); 4,4'-bis(*N-*{4-[*N*'-(3-methylphenyl)-*N*'-phenylamino]phenyl}-*N*-phenylamino)biphenyl (abbreviation: DNTPD); 1,3,5-tris[*N*-(4-diphenylaminophenyl)-*N*-phenylamino]benzene (abbreviation: DPA3B), and the like.

As the carbazole derivative that can be used for the composite material, the following can be given as examples: 3-[*N*-(9-phenylcarbazol-3-yl)-*N*-phenylamino]-9-phenylcarbazole (abbreviation: PCzPCA1); 3,6-bis[*N*-(9-phenylcarbazol-3-yl)-*N*-phenylamino]-9-phenylcarbazole (abbreviation: PCzPCA2); 3-[*N*-(1-naphthyl)-*N*-(9-phenylcarbazol-3-yl)amino]-9-phenylcarbazole (abbreviation: PCzPCN1); and the like.

As the carbazole derivative that can be used for the composite material, the following can be given as examples: 4,4'-di(*N*-carbazolyl)biphenyl (abbreviation: CBP); 1,3,5-tris[4-(*N*-carbazolyl)phenyl]benzene (abbreviation: TCPB); 9-[4-(10-phenyl-9-anthryl)phenyl]-9*H*-carbazole (abbreviation: CzPA); 1,4-bis[4-(*N*-carbazolyl)phenyl]-2,3,5,6-tetraphenylbenzene; and the like.

As the aromatic hydrocarbon that can be used for the composite material, the following can be given as examples: 2-*tert*-butyl-9,10-di(2-naphthyl)anthracene (abbreviation: t-BuDNA); 2-*tert*-butyl-9,10-di(1-naphthyl)anthracene; 9,10-bis(3,5-diphenylphenyl)anthracene (abbreviation: DPPA); 2-*tert*-butyl-9,10-bis(4-phenylphenyl)anthracene (abbreviation: t-BuDBA); 9,10-di(2-naphthyl)anthracene (abbreviation: DNA); 9,10-diphenylanthracene (abbreviation: DPAnth); 2-*tert*-butylanthracene (abbreviation: t-BuAnth); 9,10-bis(4-methyl-1-naphthyl)anthracene (abbreviation: DMNA); 9,10-bis[2-(1-naphthyl)phenyl]-2-*tert*-butylanthracene; 9,10-bis[2-(1-naphthyl)phenyl]anthracene; 2,3,6,7-tetramethyl-9,10-di(1-naphthyl)anthracene; 2,3,6,7-tetramethyl-9,10-di(2-naphthyl)anthracene; 9,9'-bianthryl; 10,10'-diphenyl-9,9'-bianthryl; 10,10'-bis(2-phenylphenyl)-9,9'-bianthryl; 10,10'-bis[(2,3,4,5,6-pentaphenyl)phenyl]-9,9'-bianthryl; anthracene; tetracene; rubrene; perylene; 2,5,8,11-tetra(*tert*-butyl)perylene; and the like. Besides these compounds, pentacene, coronene, or the like can also be used. Thus, use of an aromatic hydrocarbon which has a hole mobility of 1×10⁻⁶ cm²/Vs or more and has 14 to 42 carbon atoms is more preferable.

The aromatic hydrocarbon that can be used for the composite material may have a vinyl skeleton. As the aromatic hydrocarbon having a vinyl skeleton, the following can be given as examples: 4,4'-bis(2,2-diphenylvinyl)biphenyl (abbreviation: DPVBi); 9,10-bis[4-(2,2-diphenylvinyl)phenyl]anthracene (abbreviation: DPVPA); and the like.

The organic compound that can be used for the composite material may be a high molecular compound, and the following can be given as examples: poly(N-vinylcarbazole) (abbreviation: PVK); poly(4-vinyltriphenylamine) (abbreviation: PVTPA); poly[*N*-(4-{*N*'-[4-(4-diphenylamino)phenyl]phenyl-*N*'-phenylamino}phenyl)methacryla mide] (abbreviation: PTPDMA); poly[*N,N*'-bis(4-butylphenyl)-*N,N'*-bis(phenyl)benzidine] (abbreviation: Poly-TPD); and the like.

Above all, in terms of light transmissivity, an organic compound without an amine skeleton (e.g., a carbazole derivative or an aromatic hydrocarbon) is preferably used. A composite material using an organic compound without an amine skeleton has high transmissivity of light in a wavelength region (a wavelength region of 800 nm or more) that is absorbed by the single crystal semiconductor used for a bottom cell. Accordingly, an organic compound without an amine skeleton (e.g., a carbazole derivative or an aromatic hydrocarbon) is used, whereby high photoelectric conversion efficiency can be realized.

It is preferable that the above intermediate layer have a thickness of equal to or more than 1 nm and equal to or less than 50 nm. The intermediate layer described in this embodiment mode has a high carrier density and is excellent in a light-transmitting property; therefore, the intermediate layer can be relatively thicker than an intermediate layer formed of another material.

Various methods can be used for forming the intermediate layer, regardless of a dry method or a wet method. Further, different formation methods may be employed for each layer. As a dry method, a co-evaporation method, by which a plurality of evaporation materials is vaporized from a plurality of evaporation sources to perform deposition, and the like are given as examples. As a wet method, a composition having a composite material is adjusted by a sol-gel method or the like, and deposition can be performed using an ink-jet method or a spin-coating method.

### (Embodiment Mode 3)

In this embodiment mode, the intermediate layer in which the layer formed of the transition metal oxide described in Embodiment Mode 1 and the layer having the composite material including the transition metal oxide and the organic compound described in Embodiment Mode 2 are stacked will be described.

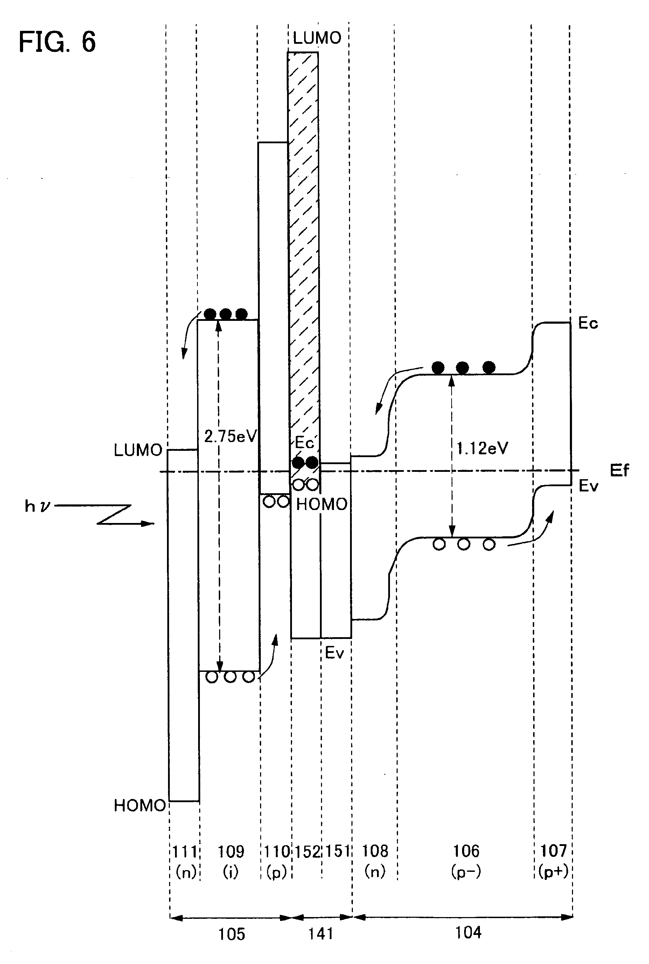

FIG 6 is an energy band diagram of the intermediate layer 141 where a layer 151 formed of a transition metal oxide and a layer 152 having a composite material in which a transition metal compound and an organic compound are compounded are stacked over the first unit cell 104. With the structure illustrated in FIG 6, the layer 152 having the composite material is formed before the second unit cell 105 that includes the organic semiconductor material is formed, whereby adhesion can be improved.

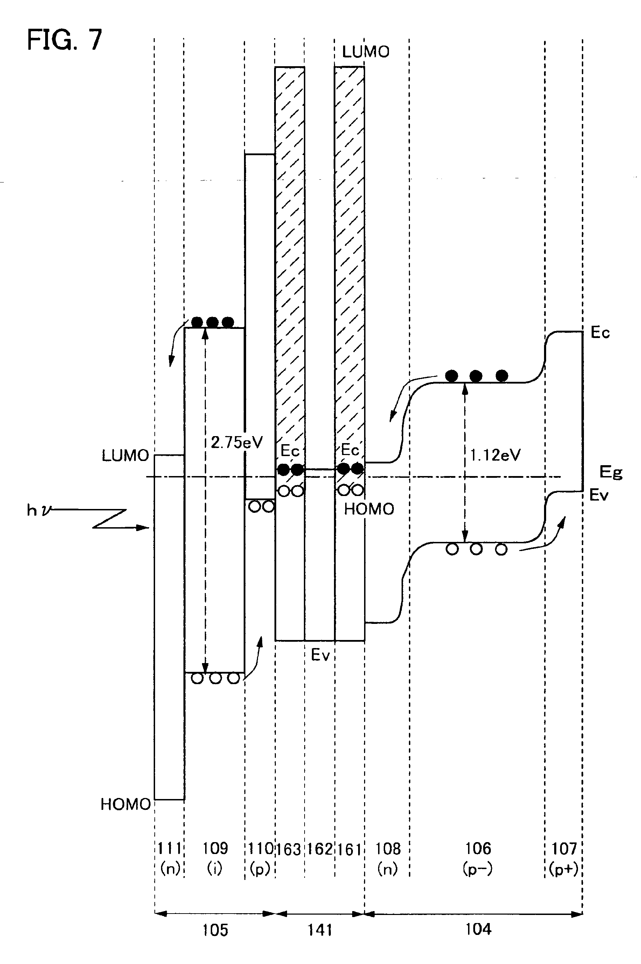

Without limitation to the above structure, the intermediate layer may be formed using at least one layer formed of a transition metal oxide and at least one layer having a composite material. Also in that case, it is preferable that a layer having a composite material be formed to be in contact with the second unit cell 105 that includes an organic semiconductor material and adhesion be improved. FIG 7 is an energy band diagram of the intermediate layer 141 where a layer 161 having a composite material in which a transition metal compound and an organic compound are compounded, a layer 162 formed of a transition metal oxide, and a layer 163 having a composite material including a transition metal compound and an organic compound are stacked over the first unit cell 104. As illustrated in FIG 7, even if the intermediate layer has a structure in which three layers are stacked, the intermediate layer functions as a recombination center. Accordingly, by the operation of this the intermediate layer 141, recombination current can flow between the first unit cell 104 and the second unit cell 105. That is, the internal electromotive force effect which is generated by direct bond of the second impurity semiconductor layer 108 and the p layer 110 can be eliminated, and the conversion efficiency of a tandem photoelectric conversion device can be increased.

### (Embodiment Mode 4)

In this embodiment mode, a method of manufacturing the photoelectric conversion device 100 with its cross-sectional structure taken along section line A-B of FIG 1 corresponding to the structure illustrated in FIG 2 will be described.

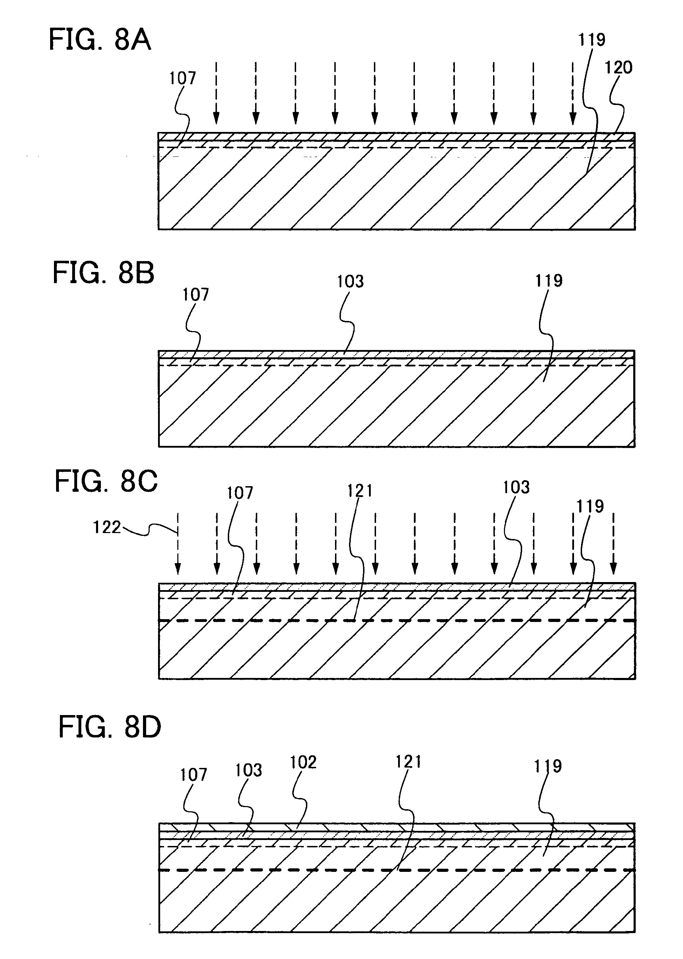

A semiconductor substrate 119 illustrated in FIG 8A is a substrate with substantially quadrangular shape which is obtained by being cut out from a circular single crystal semiconductor substrate. Needless to say, the planar shape of the semiconductor substrate 119 is not limited in particular; however, the semiconductor substrate 119 preferably has a substantially quadrangular shape in the case where a supporting substrate which supports a single crystal semiconductor layer is rectangular. The semiconductor substrate 119 is typically single crystal silicon and preferably has a surface which has been subjected to mirror polishing. This is because the semiconductor substrate 119 is disposed in close contact with the supporting substrate with an insulating layer for bonding interposed therebetween. For example, a p-type single crystal silicon wafer with a resistivity of about 1 Ωm to 10 Ωcm is used as the semiconductor substrate 119. It is preferable that the planar shape of the semiconductor substrate 119 be substantially quadrangular as described above.

It is preferable that a protection film 120 be formed of silicon oxide or silicon nitride and a chemical vapor deposition method typified by a plasma CVD method is used for the formation. The protection film 120 is preferably provided because the planarity of the surface of the semiconductor substrate 119 is lost due to irradiation with ions in forming a damaged layer or an impurity semiconductor layer in the semiconductor substrate 119. It is preferable that the protection film 120 be provided to have a thickness of 50 nm to 200 nm.

Next, the first impurity semiconductor layer 107 including one conductivity type is formed in the semiconductor substrate 119. For example, boron is added as an impurity which imparts one conductivity type so that the first impurity semiconductor layer 107 can be formed to have p-type conductivity. In the photoelectric conversion device of this embodiment mode, the first impurity semiconductor layer 107 is arranged on the opposite side to a surface from which light enters to form a back surface field (BSF). It is preferable that boron be added using an ion doping apparatus by which a substrate is irradiated with ions which are generated without mass separation with B₂H₆ or BF₃ used as a source gas and are accelerated by an electric field. This is because, even when the diagonal of the semiconductor substrate 119 is as large as more than 300 mm, the area to be irradiated with the ion beam can be enlarged to perform the process effectively. For example, a linear ion beam with a long side length of more than 300 mm is formed and used to irradiate the semiconductor substrate 119 from one end to the other end, so that the first impurity semiconductor layer 107 can be uniformly formed over the entire surface of the semiconductor substrate 119.

In FIG 8B, the protection film 120 is removed, and the first electrode 103 is formed over the first impurity semiconductor layer 107. It is preferable that the first electrode 103 be formed of a heat-resistant metal. As the heat-resistant metal, a metal material such as titanium, molybdenum, tungsten, tantalum, chromium, or nickel is used. The first electrode 103 may have a stacked structure by forming a nitride of any of these metal materials in contact with the first impurity semiconductor layer 107. By the formation of the metal nitride, adhesion between the first electrode 103 and the first impurity semiconductor layer 107 can be improved. The first electrode 103 is formed by a vacuum evaporation method or a sputtering method.

FIG 8C illustrates a step of forming a damaged layer 121 by irradiating the semiconductor substrate 119 from the surface which is provided with the first electrode 103 with ion beams 122 including hydrogen ions. As the hydrogen ions, preferably, cluster ions typified by H₃⁺, which has heavier mass than a hydrogen molecule, are introduced to form the damaged layer 121 at a certain depth from the surface. The depth of the damaged layer 121 is controlled with the acceleration energy of the ions. The thickness of the single crystal semiconductor layer separated from the semiconductor substrate 119 is determined depending on the depth of the damaged layer 121; therefore, the electric field intensity for accelerating cluster ions is determined in consideration of the depth of the damaged layer 121. It is preferable that the damaged layer 121 be formed at a depth of less than 10 µm, that is, equal to or more than 50 nm and less than 10,000 nm, preferably from 100 nm to 5,000 nm from the surface of the semiconductor substrate 119. By introducing the cluster ions into the semiconductor substrate 119 through the first electrode 103, the surface of the semiconductor substrate 119 can be prevented from being damaged by the ion irradiation.

The hydrogen cluster ions typified by H₃⁺ can be introduced using an ion doping apparatus in such a manner that hydrogen plasma is generated and ions generated in the plasma are accelerated by an electric field without mass separation. With the use of the ion doping apparatus, ion irradiation can be easily performed even on the semiconductor substrate 119 having a larger area.

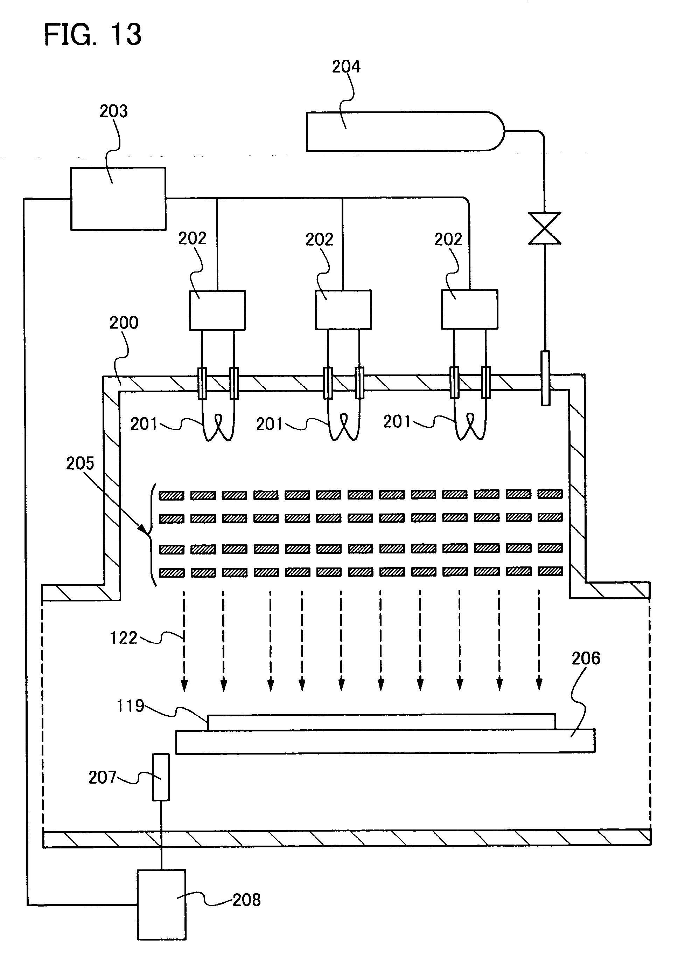

FIG 13 is a schematic view illustrating a structure of an ion doping apparatus by which plural kinds of ions generated in an ion source 200 are introduced to the semiconductor substrate 119 without mass separation. A predetermined gas such as hydrogen is supplied from a gas supply portion 204 to the ion source 200. The ion source 200 is provided with a filament 201. A filament power source 202 applies ark discharge voltage to the filament 201 and controls the amount of current that flows to the filament 201. The gas supplied from the gas supply portion 204 is exhausted through an exhaustion system.

The ions generated in the ion source 200 are extracted through an extraction electrode system 205 to form the ion beams 122. The semiconductor substrate 119 disposed on a mounting board 206 is irradiated with the ion beams 122. The proportions of ion species in the ion beams 122 are calculated with a mass spectrometer tube 207 provided near the mounting board 206. The ion density calculated with the mass spectrometer tube 207 is converted into signals by using a mass spectrometer 208 and the results may be fed back to a power source controller 203. The filament power source 202 can be controlled by the power source controller 203 in accordance with the calculation results on the ion density.

As illustrated in FIG 13, the gas of hydrogen or the like supplied from the gas supply portion 204 flows through a chamber of the ion doping apparatus and is exhausted through the exhaustion system 209. Hydrogen supplied to the ion source 200 is ionized through a reaction represented by a formula (1):

H₂ + e⁻ → H₂⁺ + 2e⁻ - Q (Q = 15.39 eV) (1)

The pressure in the chamber of the ion doping apparatus is from 1 × 10⁻² Pa to 1 × 10⁻¹ Pa, and the ionization degree is not so high; therefore, there is H₂, which is the source gas, in a larger amount than that of H₂⁺ ions. Therefore, H₂⁺ ions generated in the ion source react with H₂ before the extraction through the extraction electrode system 205, and the reaction is represented by a formula (2):

H₂⁺ + H₂ → H₃⁺ + H + Q (Q = 1.49 eV) (2)

H₃⁺ exists as a more stable molecule than H⁺ and H₂⁺; therefore, as the proportion of collision with H₂ becomes higher, the amount of H₃⁺ generated is increased.

This is clear from the mass spectrometry result of the ion beams 122 flowing onto the mounting board 206 which is obtained with the use of the mass spectrometer tube 207; the proportion of H₃⁺ ions with respect to the total amount of ion species H⁺, H₂⁺, and H₃⁺ is 70% or more. Accordingly, the substrate is irradiated with ion beams in which a large amount of H₃⁺, which are cluster ions, are generated, which leads to a significant effect of improving the introduction efficiency of hydrogen atoms as compared to the case of introduction of H⁺ or H₂⁺ and introducing hydrogen into the semiconductor substrate 119 at a high concentration even if the dose is small.

As described above, a high proportion of H₃⁺ enables the damaged layer 121 to include hydrogen at a concentration of I × 10²⁰ atoms/cm³ or more. In the damaged layer 121 formed in the semiconductor substrate 119, a crystal structure is damaged and microvoids are formed, so that a porous structure is formed. Therefore, the volume of the microvoids formed in the damaged layer 121 is changed by thermal treatment at a relatively low temperature (600°C or lower), and cleavage can be performed along the damaged layer 121 to obtain the single crystal semiconductor layer.

The surface of the semiconductor substrate 119 may be scanned with a linear ion beam having a larger length than that of one side of the semiconductor substrate 119 with a substantially quadrangular shape to introduce cluster ions, whereby the depth at which the damaged layer 121 is formed can be uniform.

FIG 8D illustrates a step of forming the insulating layer 102 over the first electrode 103. The insulating layer 102 is formed of an insulating film such as a silicon oxide film, a silicon oxynitride film, a silicon nitride oxide film, or a silicon nitride film. There is no limitation on the material for forming the insulating layer 102 as long as an insulating film can be formed, and any film may be used for the insulating layer 102 as long as it has a smooth surface and forms a hydrophilic surface. As for the smoothness of the insulating layer 102, the mean surface roughness (*Ra*) is preferably 1 nm or less, more preferably 0.5 nm or less. The 'mean surface roughness' in this specification refers to a mean surface roughness obtained by three-dimensionally expanding centerline mean roughness which is defined by JIS B0601 so as to be applied to a plane.

Note that the silicon oxynitride film means a film that has higher content of oxygen than nitrogen and shows concentration ranges of oxygen, nitrogen, silicon, and hydrogen from 55 at.% to 65 at.%, 0.5 at.% to 20 at.%, 25 at.% to 35 at.%, and 0.1 at.% to 10 at.%, respectively. Further, the silicon nitride oxide film means a film that has higher content of nitrogen than oxygen and shows concentration ranges of oxygen, nitrogen, silicon, and hydrogen from 15 at.% to 30 at.%, 20 at.% to 50 at.%, 25 at.% to 35 at.%, and 15 at.% to 25 at.%, respectively.

As silicon oxide containing hydrogen, for example, silicon oxide deposited by a chemical vapor deposition method using organosilane is preferable. This is because, for example, with a Inposelstartsilicon oxide filmlnposelend used as the insulating layer 102 which is deposited using organosilane, a bond between the supporting substrate and a semiconductor layer for transfer can be made strong. For the organosilane, a compound which contains silicon, such as tetraethoxysilane (TEOS) (chemical formula: SI(OC₂H₅)₄), tetramethylsilane (TMS) (chemical formula: Si(CH₃)₄), tetramethylcyclotetrasiloxane (TMCTS), octamethylcyclotetrasiloxane (OMCTS), hexamethyldisilazane (HMDS), triethoxysilane (SiH(OC₂H₅)₃), or tris(dimethylamino)silane (SiH(N(CH₃)₂)₃) can be used.

Silicon nitride containing hydrogen can be deposited by a plasma CVD method using a silane gas and an ammonia gas. Hydrogen may be added to the above gases. Silicon nitride containing oxygen and hydrogen can be deposited by a plasma CVD method using a silane gas, an ammonia gas, and a nitrous oxide gas. In any case, any silicon oxide, silicon oxynitride, silicon nitride oxide, or silicon nitride which contains hydrogen and is deposited by a chemical vapor deposition method such as a plasma CVD method, a low-pressure CVD method, or an atmospheric-pressure CVD method using a silane gas or the like as a source gas can be used. As a deposition temperature of the insulating layer 102 at which hydrogen is not desorbed from the damaged layer 121 formed in the single crystal semiconductor substrate, a deposition temperature of 350°C or lower is recommended.

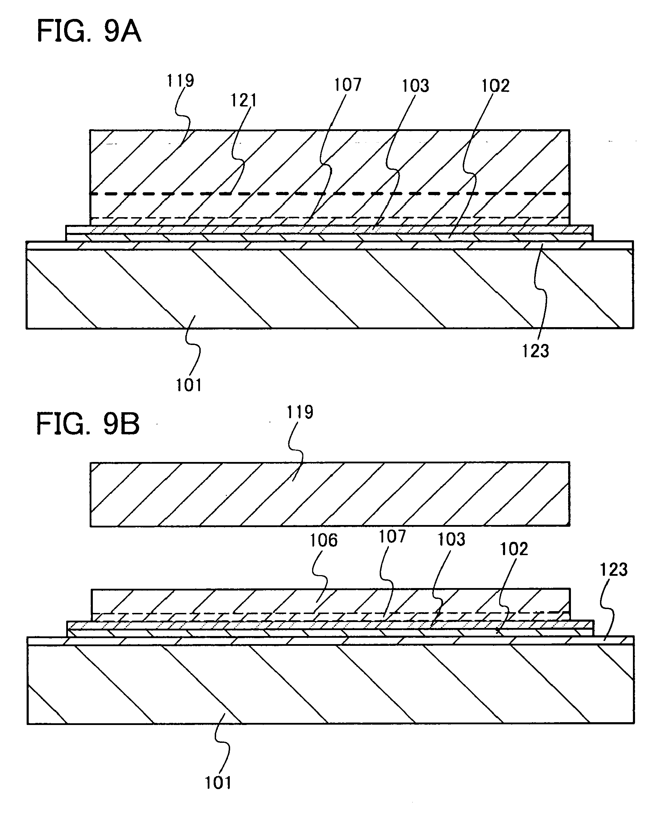

FIG 9A illustrates a step of bonding the supporting substrate 101 and the semiconductor substrate 119 to each other. This bonding is made in such a manner that the insulating layer 102 having a smooth surface and forming a hydrophilic surface is disposed in close contact with the supporting substrate 101. This bond is formed by a hydrogen bond or van der Waals forces. A hydrogen bond is formed when a surface of the substrate has a hydrophilic property, a hydroxyl group or a water molecule functions as an adhesive, the water molecule is diffused by thermal treatment, and a remaining component forms a silanol group (Si-OH). Further, in this bonding portion, by hydrogen being released, a siloxane bond (an O-Si-O bond) is formed to generate a covalent bond, so that the bond between the semiconductor substrate 119 and the supporting substrate 101 can be made strong. Note that a silicon nitride film, a silicon nitride oxide film, or the like may be formed as a barrier layer 123 at a bonding surface of the supporting substrate 101. The provision of the barrier layer 123 can prevent contamination due to impurities from the supporting substrate 101.

In order to efficiently bond the supporting substrate 101 and the insulating layer 102 to each other, the bonding surfaces thereof are preferably activated in advance. For example, one or both of the bonding surfaces are irradiated with an atom beam or an ion beam. In the case of using an atom beam or an ion beam, a neutral atom beam or ion beam of an inert gas such as argon can be used. Alternatively, the bonding surfaces can be activated by performing plasma irradiation or radical treatment. Such surface treatment facilitates formation of a bond between different materials even at a temperature of 400°C or lower.

FIG 9B illustrates a step of separating part of the semiconductor substrate 119 from the supporting substrate 101 by heat treatment, with the damaged layer 121 serving as a cleavage plane. The heat treatment is preferably performed at a temperature which is equal to or higher than the deposition temperature of the insulating layer 102 and equal to or lower than the upper temperature limit of the supporting substrate 101. For example, the heat treatment is performed at 400°C to 670°C, so that the volume of microvoids formed in the damaged layer 121 is changed, and the semiconductor substrate 119 is cleaved along the region. Since the insulating layer 102 is bonded to the supporting substrate 101, the single crystal semiconductor layer 106 and the first electrode 103 remain over the supporting substrate 101. At this time, the thickness of the single crystal semiconductor layer 106 approximately corresponds to the depth at which the damaged layer 121 is formed, and the single crystal semiconductor layer 106 has a thickness of equal to or more than 50 nm and less than 10,000 nm, preferably from 100 nm to 5,000 nm.

Through the above-described steps, the single crystal semiconductor layer 106, which is fixed over the supporting substrate 101 with the insulating layer 102, can be provided.

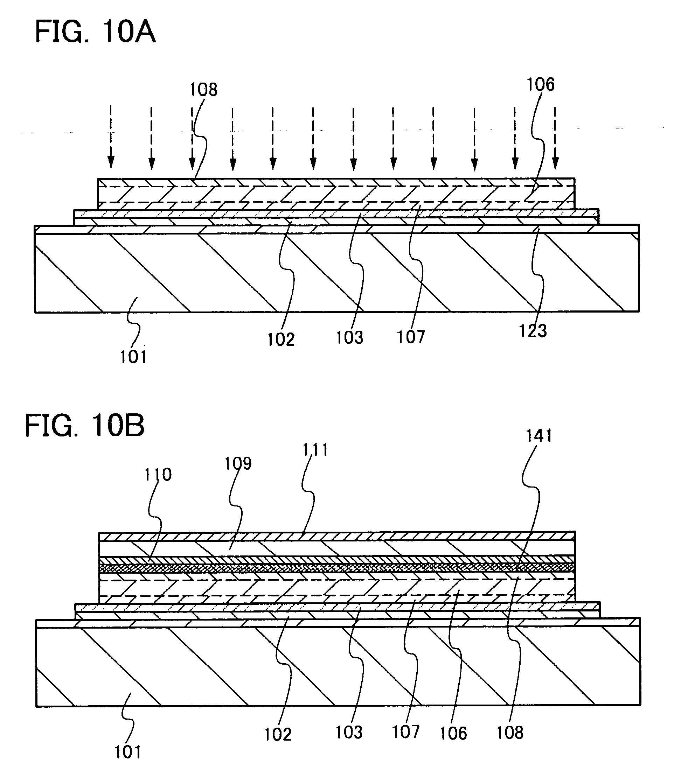

FIG 10A illustrates a step of adding an impurity having an opposite conductivity type to that of the first impurity semiconductor layer 107 to the single crystal semiconductor layer 106 to form the second impurity semiconductor layer 108. For example, phosphorus or arsenic is added, so that the second impurity semiconductor layer 108 has n-type conductivity. It is preferable that the surface of the single crystal semiconductor layer 106 be removed by etching in advance because it is the closest to the damaged layer 121 or contains part of the damaged layer 121. Either dry etching or wet etching is performed.

Next, as illustrated in FIG 10B, the intermediate layer 141, the p layer 110, the i layer 109, and the n layer 111 are formed. The intermediate layer 141 has a thickness of 1 nm to 100 nm. A p-type semiconductor layer has a thickness of 10 nm to 30 nm as the p layer 110. A layer in which a p-type semiconductor and an n-type semiconductor are mixed has a thickness of 10 nm to 100 nm as the i layer 109. An n-type semiconductor layer has a thickness of 10 nm to 30 nm as the n layer 111.

Although the intermediate layer 141 can be formed by any of various kinds of methods, the intermediate layer 141 is preferably formed by an evaporation method or a co-evaporation method. The co-evaporation method indicates an evaporation method by which evaporation is concurrently conducted from a plurality of evaporation sources in one treatment chamber. It is preferable that deposition be performed in a reduced-pressure atmosphere. The reduced-pressure atmosphere can be obtained by evacuation of the deposition chamber with an evacuation unit to a vacuum of about 5 x 10⁻³ Pa or less, preferably, about 10⁻⁴ Pa to 10⁻⁶ Pa.

Various methods can be used for forming the p layer 110, the i layer 109, and the n layer 111, regardless of a dry method or a wet method. Further, different formation methods may be employed for each layer. For example, the p layer 110 can be formed by a vacuum evaporation method; the i layer can be formed by co-evaporation of a p-type semiconductor and an n-type semiconductor; and the n layer can be formed by a vacuum evaporation method. When the second unit cell is desired to be formed not over the entire surface of the substrate but only in a necessary region, a shadow mask may be used and deposition may be performed only in a necessary region.

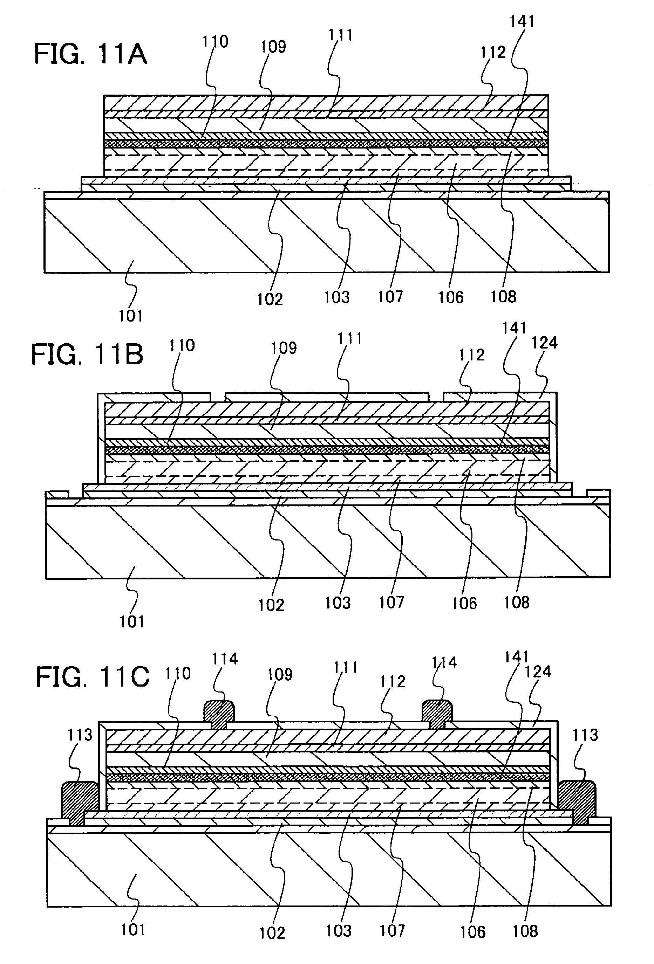

As illustrated in FIG 11A, the second electrode 112 is formed over the n layer 111. The second electrode 112 is formed using a transparent conductive material. As the transparent conductive material, a metal oxide such as an indium tin oxide (ITO) alloy, zinc oxide (ZnO), tin oxide (SnO₂), or an ITO-ZnO alloy is used. The thickness of the second electrode 112 is 40 nm to 200 nm (preferably, 50 nm to 100 nm). The sheet resistance of the second electrode 112 may be about 20 Ω/square to 200 Ω/square.

The second electrode 112 is formed by a sputtering method or a vacuum evaporation method. In this case, the second electrode 112 is formed using a shadow mask so that the second electrode 112 can be selectively formed in a region where the first unit cell and the second unit cell overlap with each other.

Note that a conductive high molecular material (also called a 'conductive polymer') can be used instead of the above-described metal oxide in order to form the second electrode 112. As the conductive high molecular material, π electron conjugated conductive polymer can be used. For example, polyaniline and/or a derivative thereof, polypyrrole and/or a derivative thereof, polythiophene and/or a derivative thereof, and a copolymer of two or more kinds of those materials can be given. When a conductive high molecule is used for the second electrode 112, deposition can be performed using a wet method such as an ink-jet method or a screen printing method.

Note that, in terms of suppressing damage to an organic layer under the second electrode, the second electrode is preferably formed by a vacuum evaporation method or a wet method.

FIG 11B illustrates a step of forming a passivation layer 124, which also serves as an anti-reflection layer, over the supporting substrate 101 provided with the first unit cell 104 and the second unit cell 105. The passivation layer 124 is formed of silicon nitride, silicon nitride oxide, or magnesium fluoride. Opening portions are formed in the passivation layer 124 so that parts of the surfaces of the first electrode 103 and the second electrode 112 can be exposed to form a contact with auxiliary electrodes, The opening portions of the passivation layer 124 are formed by an etching process. Alternatively, a passivation layer provided with opening portions is formed as the passivation layer 124; in this case, a method using a shadow mask as described above, or a method using a lift-off method can be employed.

FIG 11C illustrates a step of forming the first auxiliary electrode 113, which is in contact with the first electrode 103, and the second auxiliary electrode 114, which is in contact with the second electrode 112. As illustrated in FIG 1, the second auxiliary electrode 114 is a comb-shaped or lattice-shaped electrode. The first auxiliary electrode 113 and the second auxiliary electrode 114 may be formed of aluminum, silver, lead-tin (solder), or the like. For example, the first auxiliary electrode 113 and the second auxiliary electrode 114 are formed by a screen printing method using a silver paste.

Through the above-described process, the photoelectric conversion device can be manufactured. According to the process in this embodiment mode, a technique of bonding different materials is used, so that a photoelectric conversion device which includes a bottom cell including a single crystal semiconductor layer with a thickness of 10 µm or less as a photoelectric conversion layer and a top cell, which is stacked over the bottom cell and includes an organic semiconductor layer as a photoelectric conversion layer, can be manufactured at a process temperature of 700°C or lower (preferably, 500°C or lower). That is, the photoelectric conversion device which includes the bottom cell that includes the single crystal semiconductor layer as a photoelectric conversion layer and the top cell that includes the organic semiconductor layer as a photoelectric conversion layer and is stacked over the bottom cell can be manufactured over a large-area glass substrate having an upper temperature limit of 700°C or lower. The single crystal semiconductor layer is obtained by separating a surface portion of the single crystal semiconductor substrate. The single crystal semiconductor substrate can be used repeatedly, which leads to effective use of resources.

### (Embodiment Mode 5)

In Embodiment Mode 4, in some cases, due to the formation of the damaged layer 121, crystal defects remain at the surface of the single crystal semiconductor layer 106 which is exposed through the separation of part of the semiconductor substrate 119 as illustrated in FIG 9B. In those cases, it is preferable that the surface of the single crystal semiconductor layer 106 be removed by etching. For the etching, either dry etching or wet etching is performed. Further, in some cases, a rough surface in which mean surface roughness (*Ra*) is 7 nm to 10 nm and the largest difference in height between peak and valley (P-V) is 300 nm to 400 nm remains on the plane of the single crystal semiconductor layer 106 along which the part of the semiconductor substrate 119 is cleaved. The "largest difference in height between peak and valley" in this specification refers to a difference in height between the peak and the valley. The "peak" and the "valley" in this specification refer to a peak and a valley obtained by three-dimensional expansion of the "peak" and the "valley" defined by JIS B0601. The peak is represented as the highest part of the peaks in a specified plane. The valley is represented as the lowest part of the valleys in a specified plane.

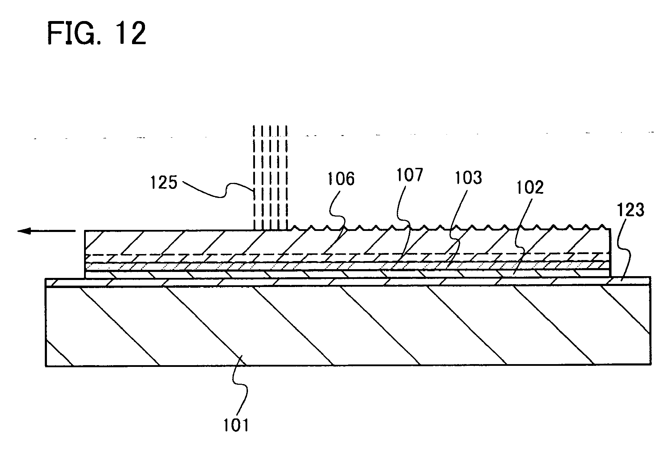

Furthermore, in order to repair the single crystal semiconductor layer 106 in which crystal defects remain, it is preferable to perform laser treatment. FIG 12 illustrates the laser treatment performed on the single crystal semiconductor layer 106. The single crystal semiconductor layer 106 is irradiated with a laser beam 125, so that at least the surface side of the single crystal semiconductor layer 106 is melted and is recrystallized in the following cooling step, using a lower portion of the single crystal semiconductor layer 106 in a solid-phase state as seed crystals. In this manner, defects of the single crystal semiconductor layer 106 can be repaired. Further, if the laser treatment is performed in an inert gas atmosphere, the surface of the single crystal semiconductor layer 106 can be planarized.

For this laser treatment, it is preferable that at least a region which is irradiated with a laser beam be heated at 250°C to 600°C. The region which is irradiated is heated, whereby the melting time by the laser beam irradiation can be lengthened, and defects can be repaired more effectively. The laser beam 125 melts the surface side of the single crystal semiconductor layer 106, but hardly heats the supporting substrate 101; thus, a supporting substrate having a low upper temperature limit, such as a glass substrate, can be used. In addition, since the first electrode 103 is formed of a heat-resistant metal, the first electrode 103 does not adversely affect the single crystal semiconductor layer 106 even if the single crystal semiconductor layer 106 is heated at the above-described temperature. Silicide is formed at an interface between the metal and the first impurity semiconductor layer 107, so that current flows more smoothly. Activation of the second impurity semiconductor layer 108 can also be performed by this laser treatment.

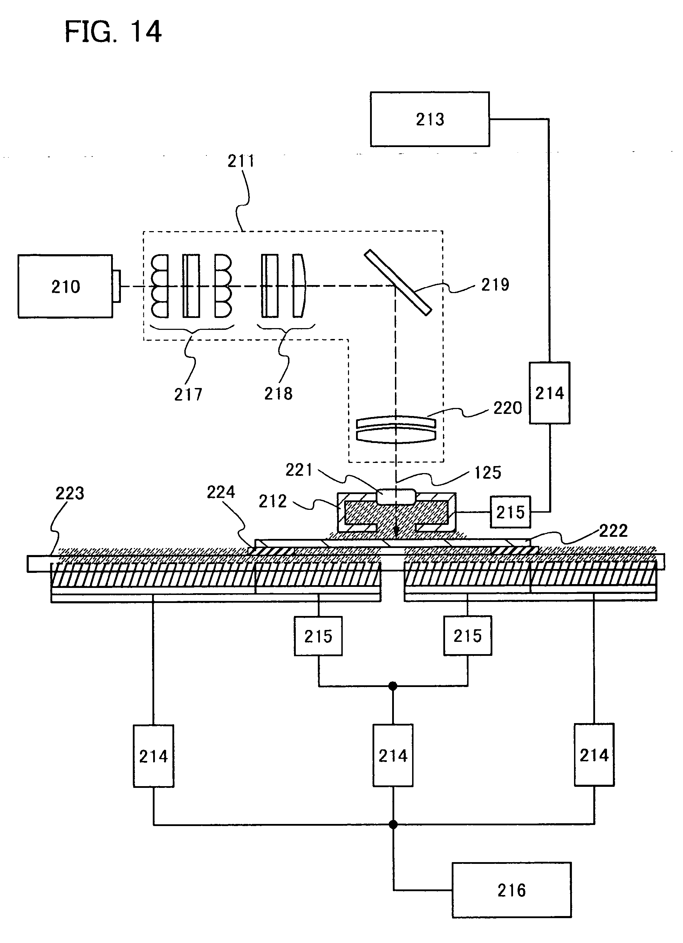

An example of a laser treatment apparatus for this laser treatment will be described with reference to FIG 14. The laser treatment apparatus is provided with a laser 210, an optical system 211, which condenses and extends laser light into a thin linear beam, a gas jetting pipe 212, which controls the atmosphere of a region which is irradiated with a laser, a gas supply portion 213, which supplies a gas for controlling the atmosphere to the gas jetting pipe 212, a flow rate control portion 214, a gas heating portion 215, a substrate stage 222, which floats and carries the supporting substrate 101, a guide rail 223, which carries the substrate while supporting both ends of the substrate, and a gas supply portion 216, which supplies a gas for floating to the substrate stage 222.

As the laser 210, a laser which emits light with a wavelength in a range from ultraviolet to visible light is selected. The laser 210 is preferably a pulsed ArF, KrF, or XeCl excimer laser, or a solid-state laser such as a Nd-YAG laser or YLF laser, with a repetition rate of 1 MHz or less and a pulse width of equal to or greater than 10 ns and equal to or less than 500 ns. A XeCl excimer laser with a repetition rate of 10 Hz to 300 Hz, a pulse width of 25 ns, and a wavelength of 308 nm can be used, for example.

The optical system 211 condenses and extends laser light to form a laser beam of linear cross-section on a surface to be irradiated. The optical system 211, which forms a linear beam, includes a cylindrical lens array 217, a cylindrical lens 218, a mirror 219, and a doublet cylindrical lens 220. Irradiation with the linear laser beam of about 100 mm to 700 mm in a long-side direction and about 100 µm to 500 µm in a short-side direction can be performed, though it depends on the size of the lens.

The supporting substrate 101 is irradiated with the laser beam condensed into a linear shape through a light introducing window 221 of the gas jetting pipe 212. The gas jetting pipe 212 is provided to be adjacent to the supporting substrate 101. A nitrogen gas is supplied to the gas jetting pipe 212 from the gas supply portion 213. The nitrogen gas is jetted from an opening portion of the gas jetting pipe 212, which faces the supporting substrate 101. The opening portion of the gas jetting pipe 212 is provided in accordance with an optical axis of the linear laser beam so that the supporting substrate 101 can be irradiated with the laser beam which enters through the light introducing window 221. Due to the nitrogen gas jetted from the opening portion of the gas jetting pipe 212, a region which is irradiated with the laser beam comes to have a nitrogen atmosphere.

The temperature of a surface of the supporting substrate 101 which is irradiated with the laser beam can be controlled with the nitrogen gas which is supplied to the gas jetting pipe 212 and heated from 250°C to 600°C in the gas heating portion 215. By heating the region which is irradiated, melting time by the laser beam irradiation can be controlled as described above.

Air or nitrogen is supplied to the substrate stage 222 from the gas supply portion 216 through the flow rate control portion 214. A gas supplied from the gas supply portion 216 is jetted so that a bottom surface of the supporting substrate 101 can be sprayed with the gas from a top surface of the substrate stage 222; in this manner, the supporting substrate 101 is floated. The supporting substrate 101 is carried with its both ends mounted on a slider 224, which moves on the guide rail 223. Since the supporting substrate 101 is sprayed with a gas from the substrate stage 222 side, the supporting substrate 101 can be carried without being curved as it is floated. In the laser treatment apparatus of this embodiment mode, a nitrogen gas is jetted from the gas jetting pipe 212 to the top surface of the supporting substrate 101. Therefore, the supporting substrate 101 can be prevented from bending by spraying a gas also from a back side of the supporting substrate 101.

The substrate stage 222 can be divided into a region including a laser irradiation portion and the vicinity thereof, and the other region. The laser irradiation portion and the vicinity thereof of the substrate stage 222 may be sprayed with a nitrogen gas heated by the gas heating portion 215, so that the supporting substrate 101 can be heated.

The laser treatment illustrated in FIG 12 is effective in repairing defects of the single crystal semiconductor layer 106. That is, in the photoelectric conversion device, carriers (electrons and holes) generated in a semiconductor by photoelectric conversion are collected in the electrode formed on the surface of the semiconductor layer and are extracted as current. At this time, if the number of recombination centers at the surface of the semiconductor layer is large, photogenerated carriers disappear there, which degrades photoelectric conversion characteristic. Thus, repairing defects of the single crystal semiconductor layer by laser treatment is effective.

### (Embodiment Mode 6)

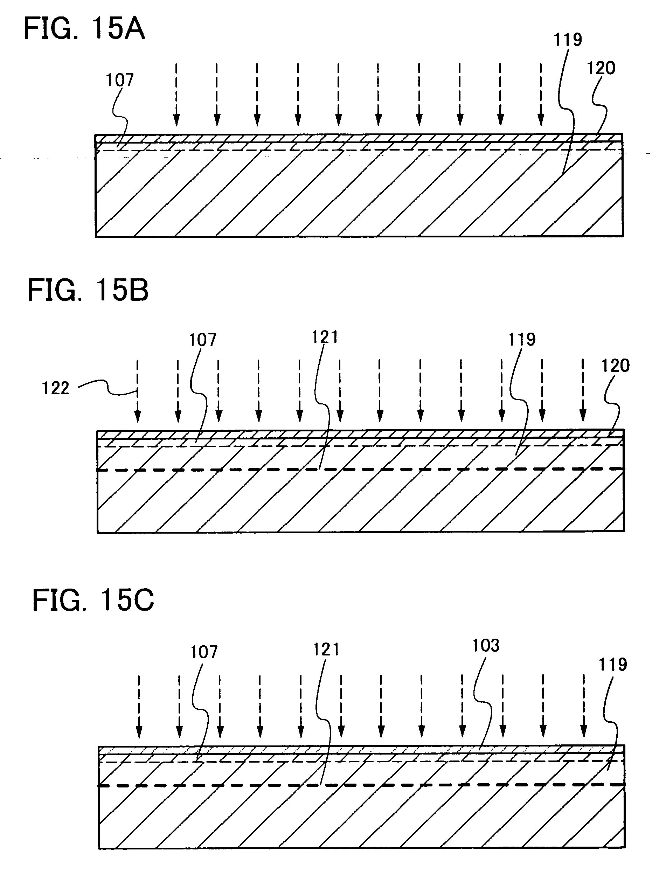

In this embodiment mode, a different manufacturing process from that in Embodiment Mode 1 will be described with reference to FIGS. 15A to 15C. The protection film 120 and the first impurity semiconductor layer 107 are formed (FIG 15A), and then, the damaged layer 121 may be formed with the protection film 120 left (FIG 15B). After that, the protection film 120 is removed and the first electrode 103 is formed (FIG 15C). Such steps make it possible to effectively use the protection film 120. That is, the protection film 120 damaged due to the irradiation with ions is removed before the first electrode 103 is formed, so that the surface of the semiconductor substrate 119 can be prevented from being damaged. In addition, since the damaged layer 121 into which hydrogen cluster ions are introduced is formed through the first impurity semiconductor layer 107, hydrogenation of the first impurity semiconductor layer 107 can also be performed.

### (Embodiment Mode 7)

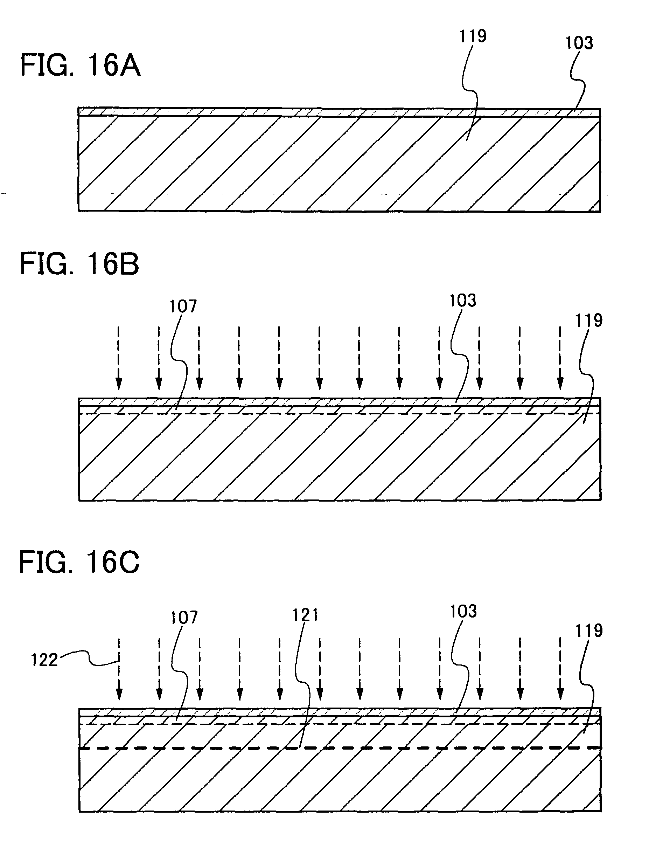

In this embodiment mode, a different manufacturing process from that in Embodiment Mode 1 will be described with reference to FIGS. 16A to 16C. The semiconductor substrate 119 is provided with the first electrode 103 (FIG 16A), and an impurity which imparts one conductivity type is added through the first electrode 103 to form the first impurity semiconductor layer 107 (FIG 16B). Then, hydrogen cluster ions are introduced through the first electrode 103 to form the damaged layer 121 (FIG 16C). In this process, the first electrode 103, which is formed first, can be used as a layer against damage due to ion doping. In addition, a step of forming a protection film for ion doping can be omitted. In addition, since the damaged layer 121 into which hydrogen cluster ions are introduced is formed through the first impurity semiconductor layer 107, hydrogenation of the first impurity semiconductor layer 107 can also be performed.

### (Embodiment Mode 8)

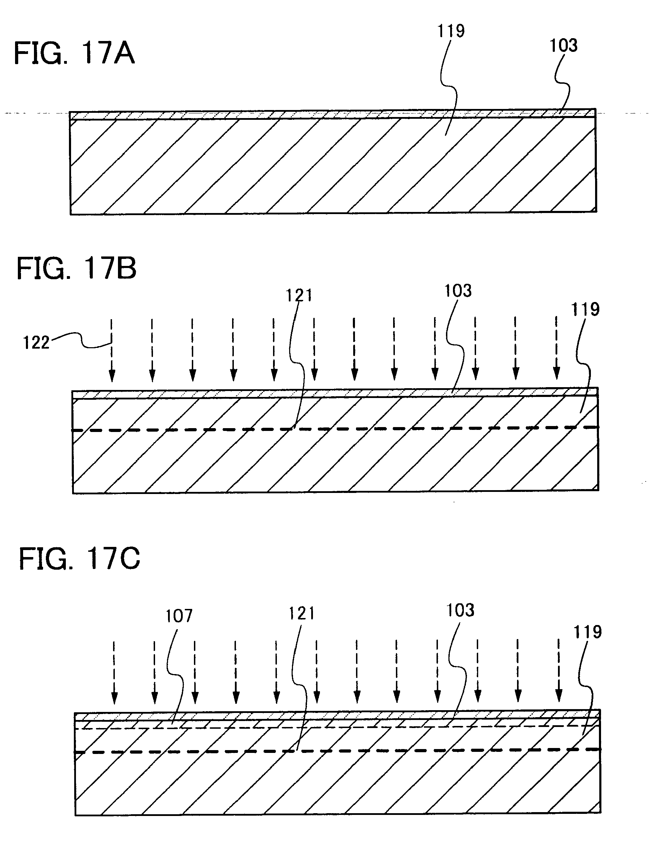

In this embodiment mode, a different manufacturing process from that in Embodiment Mode 1 will be described with reference to FIGS. 17A to 17C. The semiconductor substrate 119 is provided with the first electrode 103 (FIG 17A), and hydrogen cluster ions are introduced through the first electrode 103 to form the damaged layer 121 (FIG 17B). Then, an impurity which imparts one conductivity type is added through the first electrode 103 to form the first impurity semiconductor layer 107 (FIG 17C). In this process, the first electrode 103, which is formed first, can be used as a layer against damage due to ion doping. In this embodiment mode, a step of forming a protection film for ion doping can be omitted.

### (Embodiment Mode 9)

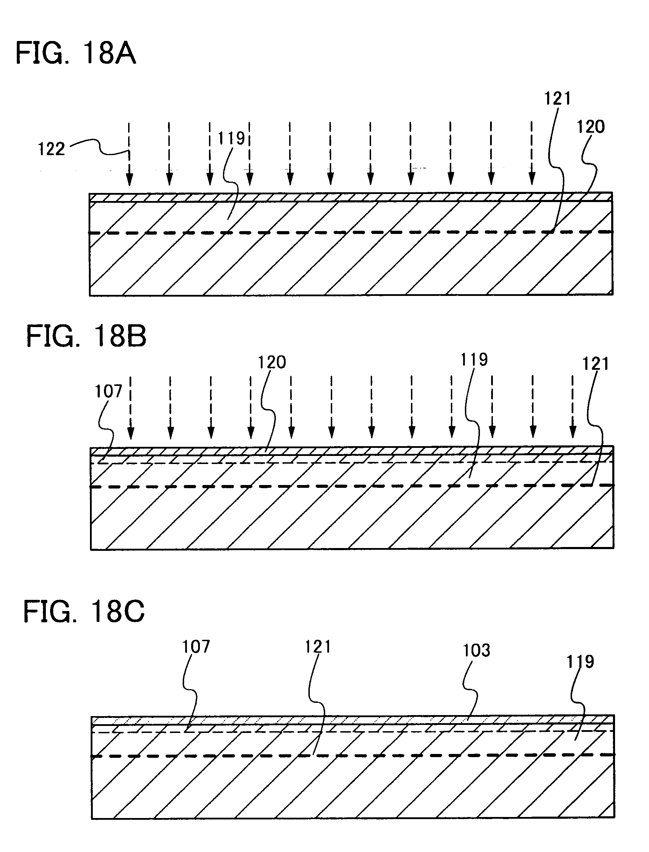

In this embodiment mode, a different manufacturing process from that in Embodiment Mode 1 will be described with reference to FIGS. 18A to 18C. The protection film 120 is formed, and hydrogen cluster ions are introduced to form the damaged layer 121 (FIG 18A), and the first impurity semiconductor layer 107 is formed with the protection film 120 left (FIG 18B). Then, the protection film 120 is removed and the first electrode 103 is formed (FIG 18C). Such steps make it possible to effectively use the protection film 120. In addition, the first impurity semiconductor layer 107 is formed after the damaged layer 121 is formed, whereby the impurity concentration of the first impurity semiconductor layer 107 can be increased and a shallow junction can be formed. Accordingly, a photoelectric conversion device which has high collection efficiency of photogenerated carriers owing to back surface field (BSF) effect can be manufactured.

### (Embodiment Mode 10)

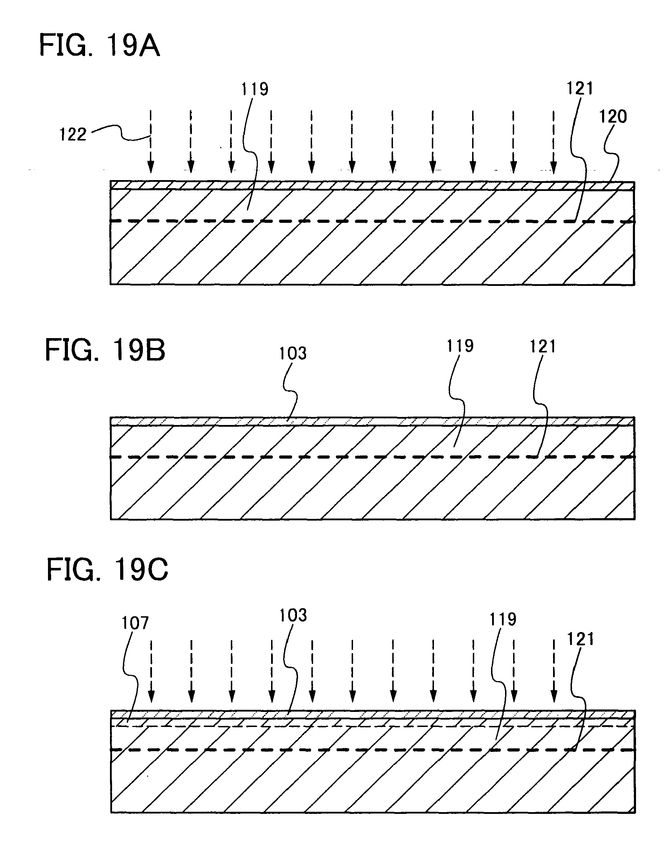

In this embodiment mode, a different manufacturing process from that in Embodiment Mode 1 will be described with reference to FIGS. 19A to 19C. The protection film 120 is formed, and hydrogen cluster ions are introduced to form the damaged layer 121 (FIG 19A). The protection film 120 is removed and the first electrode 103 is formed (FIG 19B). Then, an impurity which imparts one conductivity type is added through the first electrode 103 to form the first impurity semiconductor layer 107 (FIG 19C). Since the first impurity semiconductor layer 107 is formed by addition of the impurity through the first electrode 103, the thickness of the first impurity semiconductor layer 107 can be easily controlled.

### (Embodiment Mode 11)

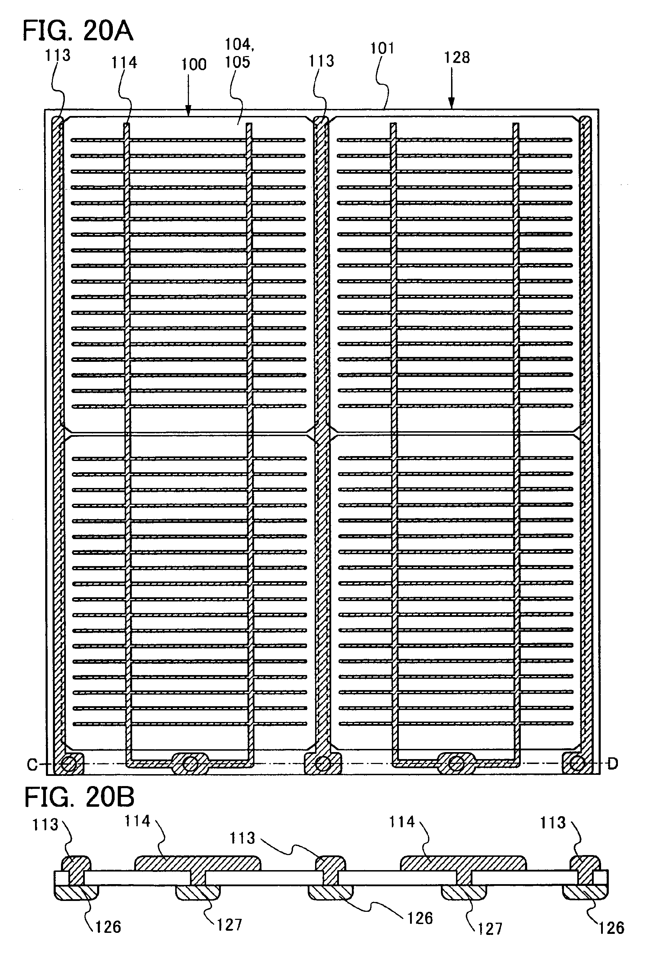

An example of a solar photovoltaic module using any photoelectric conversion device manufactured according to Embodiment Modes 1 to 10 is illustrated in FIG 20A. This solar photovoltaic module 128 includes the first unit cell 104 and the second unit cell 105 provided over the supporting substrate 101.

The first auxiliary electrode 113 and the second auxiliary electrode 114 are formed over a face of the supporting substrate 101 and connected to a first rear electrode 126 and a second rear electrode 127 for connector, respectively, at an end region of the supporting substrate 101. FIG 20B is a cross-sectional view taken along section line C-D of FIG 20A. The first auxiliary electrode 113 is connected to the first rear electrode 126 and the second auxiliary electrode 114 is connected to the second rear electrode 127 through pass-through openings of the supporting substrate 101.

The photoelectric conversion device 100 is manufactured in which the first supporting substrate 101 is provided with the first unit cell 104 and the second unit cell 105 as described above, whereby reduction in thickness of the solar photovoltaic module 128 can be achieved.

### (Embodiment Mode 12)

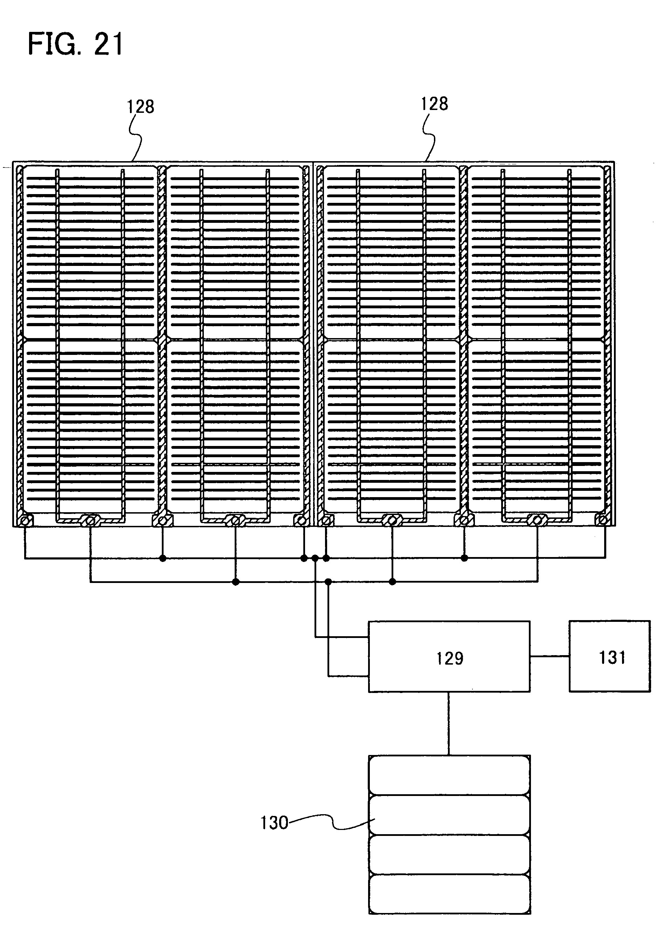

FIG 21 illustrates an example of a solar photovoltaic system using the solar photovoltaic module 128. A charge control circuit 129 charges a rechargeable battery 130 with output power of one or a plurality of solar photovoltaic modules 128. In the case where the amount of charge in the rechargeable battery 130 is large, the output power of the solar photovoltaic module 128 is directly output to a load 131 in some cases.

When an electric double layer capacitor is used for the rechargeable battery 130, a chemical reaction is not needed for charging and the battery can be charged rapidly. The lifetime of the rechargeable battery 130 can be increased to about 8 times and the charge-discharge efficiency thereof can be increased to 1.5 times as high as a lead storage battery or the like, which uses a chemical reaction. As the load 131, a lighting apparatus such as a fluorescent lamp, a light emitting diode, or an electroluminescent panel; a small electronic device; and the like can be given. In this manner, the solar photovoltaic module using the photoelectric conversion device of the present invention can be used in a variety of applications.
This application is based on Japanese Patent Application serial no. 2007-340320 filed with Japan Patent Office on December 28, 2007, the entire contents of which are hereby incorporated by reference.

## Claims

1. A photoelectric conversion device comprising:
a first unit cell comprising:
a single crystal semiconductor layer;
a first electrode and a first impurity semiconductor layer including one conductivity type, which are provided to a first face side of the single crystal semiconductor layer; and
a second impurity semiconductor layer including a conductivity type opposite to the one conductivity type provided to a second face opposite to the first face;
a second unit cell including a p-type organic semiconductor and an n-type organic semiconductor;
an intermediate layer interposed between the first unit cell and the second unit cell;
an insulating layer on a third face side of the first electrode which is opposite side to the single crystal semiconductor layer; and
a supporting substrate is bonded to the insulating layer,
wherein the first unit cell and the second unit cell are connected in series, and
wherein the intermediate layer includes a transition metal oxide.

2. The photoelectric conversion device according to claim 1, wherein the transition metal oxide is an oxide of a metal belonging to any of Group 4 to Group 8 in a periodic table of elements.

3. The photoelectric conversion device according to claim 1, wherein the transition metal oxide is any of vanadium oxide, niobium oxide, tantalum oxide, chromium oxide, molybdenum oxide, tungsten oxide, manganese oxide, and rhenium oxide.

4. The photoelectric conversion device according to claim 1, wherein the intermediate layer includes an organic compound.

5. The photoelectric conversion device according to claim 4, wherein the organic compound is any of an aromatic amine compound, a carbazole derivative, an aromatic hydrocarbon, and a high molecular compound.

6. The photoelectric conversion device according to claim 1, wherein the single crystal semiconductor layer has a thickness of equal to or more than 0.1 µm and equal to or less than 10 µm.

7. The photoelectric conversion device according to claim 1, wherein the single crystal semiconductor layer is single crystal silicon.

8. The photoelectric conversion device according to claim 1, wherein the first electrode comprises a metal selected from a group consisting of titanium, molybdenum, tungsten, tantalum, chromium, and nickel.

9. The photoelectric conversion device according to claim 8, wherein the first electrode includes a nitride layer of the metal material, and the nitride layer is in contact with the first impurity semiconductor layer.

10. The photoelectric conversion device according to claim 1, wherein the insulating layer is any of a silicon oxide layer, a silicon oxynitride layer, a silicon nitride oxide layer, and a lnposelstartlnposelstartsilicon nlnposelenditride layerlnposelend.

11. The photoelectric conversion device according to claim 1, wherein the supporting substrate is a glass substrate.

12. A method of manufacturing a photoelectric conversion device, comprising the steps of:
introducing a cluster ion to a single crystal semiconductor substrate through a first face thereof at a depth of 10 µm or less from the first face to form a damaged layer;
forming a first impurity semiconductor layer on the first face side;
forming a first electrode on the first face side;
forming an insulating layer on the first face side;
bonding a supporting substrate to the insulating layer;
cleaving the single crystal semiconductor substrate along the damaged layer to make a single crystal semiconductor layer remain over the supporting substrate;
forming a second impurity semiconductor layer on a cleavage plane side of the single crystal semiconductor layer;
forming an intermediate layer over the second impurity semiconductor layer;
forming a second unit cell including a p-type organic semiconductor and an n-type organic semiconductor over the intermediate layer; and
forming a second electrode over the second unit cell.

13. A method of manufacturing a photoelectric conversion device, comprising the steps of:
introducing an ion beam to a single crystal semiconductor substrate through a first face thereof, to form a damaged layer at a predetermined depth from the first face;
forming at least a first impurity semiconductor layer including one conductivity type, a first electrode in contact with the first impurity semiconductor layer, and an insulating layer over the first electrode, on the surface side of the single crystal semiconductor substrate to which the cluster ion is introduced;
disposing the single crystal semiconductor substrate so that a face of a supporting substrate is in contact with the insulating layer;
forming a crack in the damaged layer by a thermal treatment, and separating and removing the single crystal semiconductor substrate while a single crystal semiconductor layer remains over the supporting substrate;
forming a second impurity semiconductor layer including a conductivity type opposite to the one conductivity type on a surface side of the single crystal semiconductor layer exposed by separation;
forming an intermediate layer over the second impurity semiconductor layer;
forming a second unit cell including a p-type organic semiconductor and an n-type organic semiconductor over the intermediate layer; and
forming a second electrode over the second unit cell,
wherein the ion beam comprises a cluster ion, which has heavier mass than a hydrogen molecule, at 50% or more with respect to the total ions of the ion beam.

14. The method of manufacturing a photoelectric conversion device according to claim 12 or 13, wherein the cluster ion is H3⁺.

15. The method of manufacturing a photoelectric conversion device according to claim 12 or 13, wherein the intermediate layer includes a transition metal oxide.

16. The method of manufacturing a photoelectric conversion device according to claim 15, wherein the transition metal oxide is an oxide of a metal belonging to any of Group 4 to Group 8 in a periodic table of elements.

17. The method of manufacturing a photoelectric conversion device according to claim 15, wherein the transition metal oxide is any of vanadium oxide, niobium oxide, tantalum oxide, chromium oxide, molybdenum oxide, tungsten oxide, manganese oxide, and rhenium oxide.

18. The method of manufacturing a photoelectric conversion device according to claim 12 or 13, wherein the intermediate layer includes an organic compound.

19. The method of manufacturing a photoelectric conversion device according to claim 18, wherein the organic compound is any of an aromatic amine compound, a carbazole derivative, an aromatic hydrocarbon, and a high molecular compound.
